# EUROPEAN PATENT APPLICATION

(11) **EP 3 244 487 A1**
(43) Date of publication of application: **15.11.2017**
(21) Application number: 17174181.2
(22) Date of filing: 12.01.2007
(51) Int. Cl.: H01Q 1/50, G06K 19/07, G06K 19/077, H01Q 1/38, H01Q 1/46, H01Q 9/16, H04B 5/02, H04B 5/00, H01Q 1/22

(54) **WIRELESS IC DEVICE**

(30) Priority: 19.01.2006 JP 2006011626; 22.03.2006 JP 2006079099; 26.05.2006 JP 2006146258; 30.06.2006 JP 2006182685; 31.08.2006 JP 2006236777
(62) Divisional of application: 11164410.0
(71) Applicant: Murata Manufacturing Co., Ltd., Kyoto 617-8555 (JP)
(72) Inventor: Dokai, Yuya, Nagaokakyo-shi, Kyoto 617-8555 (JP); Kato, Noboru, Nagaokakyo-shi, Kyoto 617-8555 (JP); Ishino, Satoshi, Nagaokakyo-shi, 617-8555 (JP)
(74) Representative: Stöckeler, Ferdinand

(57) **Abstract**

A wireless IC device comprises a wireless IC chip (5), a power supply circuit board (140) connected to the wireless IC chip and a radiation plate (20), to which the power supply circuit board is adhered or disposed adjacent thereto. The power supply circuit board includes a power supply circuit including a resonant circuit having a predetermined resonant frequency. The radiation plate is arranged to perform at least one of radiation of a transmission signal supplied from the power supply circuit, and receiving of a reception signal and supplying of the reception signal to the power supply circuit. The resonant circuit is a distributed-constant resonant circuit.

## Description

### Technical Field

The present Invention relates to a wireless IC device and, in particular, to a wireless IC device used for an RFID (Radio Frequency Identification) system, and a component used for the wireless IC device.

### Background Art

In recentyears, RFID systems serving as article distribution management systems have been developed. In the RFID systems, an IC tag (hereinafter referred to as a "wireless IC device") which is stored with predetermined information about an article is attached to the article, and a reader/writer which generates a dielectric magnetic field communicates with the wireless IC device via a non-contact method, thereby transmitting information. Examples of wireless IC devices used in RFID systems are described in Patent Documents 1 and 2.

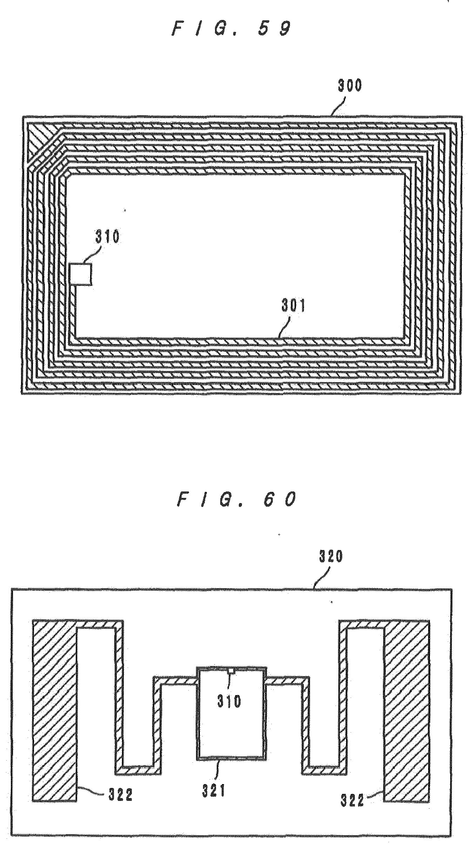

The wireless IC device shown in Fig. 59 includes an antenna pattern 301 formed on a plastic film 300, and a wireless IC chip 310 is mounted on one end of the antenna pattern 301. The wireless IC device shown in Fig. 60 includes an antenna pattern 321 and a radiation electrode 322 formed on a plasticfilm 320, and a wireless IC chip 310 is mounted on a predetermined portion of the antenna pattern 321.

However, in the existing wireless devices, the wireless IC chip 310 is DC-connected to and mounted on the antenna pattern 301 or 320 by using a Au bump. Accordingly, positioning of the small wireless IC chip 310 in the large plastic film 300 or 320 is required. However, it is very difficult to mount the small wireless IC chip 310 on the large plastic film 300 or 320 in place. If the wireless IC chip 310 is mounted out of position, the resonance frequency properties of an antenna disadvantageously change. In addition, the resonance frequency properties of an antenna change if the antenna pattern 301 or 321 is curled or is sandwiched between dielectric materials, for example, if the antenna pattern 301 or 321 is inserted into a book.
[Patent Document 1] Japanese Unexamined Patent Application Publication No. 2005-136528
[Patent Document 2] Japanese Unexamined Patent Application Publication No. 2005-244778

### Disclosure of the Invention

### Problems to be Solved by the Invention

Accordingly, the present invention provides a wireless IC device having a stable frequency characteristic and a component suitably used for the wireless IC device. Means for Solving the Problems

According to a first invention, a wireless IC device Includes a wireless IC chip, a power feeding circuit board connected to the wireless IC chip, the powerfeeding circuit board comprising a power feeding circuit including a resonance circuit having a predetermined resonance frequency, and a radiating plate having the power feeding circuit board bonded thereon or having the power feeding circuit board disposed in the vicinity thereof. The radiating plate radiates a transmission signal supplied from the power feeding circuit and/or receives and propagates a reception signal to the power feeding circuit.

In the wireless IC device according to the first invention, the wireless IC chip and the power feeding circuit board may be disposed in parallel on a wiring board and may be connected to each other via a conductor disposed on the wiring board.

According to a second invention, a wireless IC device includes a wireless IC chip, a powerfeeding circuit board having the wireless IC chip mounted thereon, the power feeding circuit board comprising a power feeding circuit including a resonance circuit having a predetermined resonance frequency, and a radiating plate having the powerfeeding circuit board bonded thereon or having the power feeding circuit board disposed in the vicinity thereof. The radiating plate radiates a transmission signal supplied from the power feeding circuit and/or receives and propagates a reception signal to the power feeding circuit.

In the wireless IC devices according to the first and second inventions, the frequency of a transmission signal radiated from the radiating plate and the frequency of a reception signal supplied to the wireless IC chip are substantially determined on the basis of the resonance frequency of the power feeding circuit included In the powerfeeding circuit board. Note that the term "substantially" means that the frequency may shift slightly in accordance with a positional relationship between the powerfeeding circuit board and the radiating plate. Since the frequency of the transmission and reception signals is determined on the basis of the power feeding circuit board, the frequency characteristic does not vary regardless of the shape, the size, and the mounting position of the radiating plate, for example, even when the wireless IC device is curled or is sandwiched by dielectric materials. Thus, a stable frequency characteristic is achieved.

In the wireless IC device according to the second invention, the wireless IC chip is mounted on the powerfeeding circuitboard, and the powerfeeding circuit it board is disposed on the radiating plate. Since the area of the power feeding circuit board is much smaller than that of the radiating plate, the wireless IC chip can be highly precisely positioned and mounted on the power feeding circuit board.

In the wireless IC devices according to the first and second inventions, the radiating plate is disposed on the first surface and the second surface of the power feeding circuit board. By sandwiching the powerfeeding circuit board by the two radiating plates, energy generated from the power feeding circuit is propagated to the radiating plates disposed on the first surface and the second surface of the power feeding circuit board. Accordingly, the gain is improved.

The resonance circuit may be a distributed constant resonance circuit or a lumped constant resonance circuit including a capacitor pattern and an inductor pattern. The distributed constant resonance circuit includes an inductor formed of strip lines or the like. Therefore, in particular, the design of the resonance circuit can be facilitated when transmission/reception signals in a high frequency band equal to or greaterthan 5 GHz are used.

The lumped constant resonance circuit may be an LC series resonance circuit or an LC parallel resonance circuit. Alternatively, the lumped constant resonance circuit may include a plurality of LC series resonance circuits or a plurality of LC parallel resonance circuits. In particular, by configuring the resonance circuit as a lumped constant resonance circuit that can be composed of a capacitor pattern and an inductor pattern, the design of the resonance circuit can be facilitated when transmission/reception signals in a low frequency band equal to or lower than 5 GHz are used. In addition, the resonance circuit is not easily affected by other elements, such as the radiating plate. Furthermore, by configuring the resonance circuit as a combination of a plurality of resonance circuits, the plurality of resonance circuits are coupled with each other. Thus, transmission/reception signals in a broader frequency band can be used.

When the capacitor pattern is disposed downstream of the wireless IC chip and between the wireless IC chip and the inductor pattern, the surge resistance is improved. Since surge is a low-frequency electrical current equal to or lower than 200 MHz, the surge can be suppressed by the capacitance element. Thus, the wireless IC chip can be protected from surge.

In addition, the capacitor pattern and the Inductor pattern may be disposed parallel to the radiating plate. That is, by disposing the capacitor pattern and the inductor pattern so as not to be aligned toward the radiating plate and so that an electric field generated by the capacitor pattern and a magnetic field generated by the inductorpattern are directly applied to the radiating plate, the magnetic field generated by the inductor pattern is not blocked by the capacitor pattern. Accordingly, the radiation efficiency of the inductor pattern is improved. Furthermore, a reflector and/or a wave director may be disposed at a portion where a magnetic field is formed by the inductor pattern. Thus, the radiation characteristic or directivity of the magnetic field from the power feeding circuit to the radiating plate can be easily controlled, and therefore, an external electromagnetic interference is minimized. As a result, a stable resonance characteristic can be obtained.

The power feeding circuit board may be a multilayer board in which a plurality of dielectric layers or a plurality of magnetic layers are stacked. In such a case, the capacitor pattern and the inductor pattern are formed on a surface of and/or inside the multilayer board. By using a resonance circuit composed of the multilayer board, an element (e.g., an electrode pattern) of the resonance circuit can be formed inside the board as well as on a surface of the board. Accordingly, the size of the board can be reduced. In addition, flexibility of the layout of the resonance circuit elements is improved. Thus, the performance of the resonance circuit is improved. The multilayer board may be a resin multilayer board in which a plurality of resin layers are stacked or a ceramic multilayer board in which a plurality of ceramic layers are stacked. Alternatively, the multilayer board may be a thin-film multilayer board produced by using a thin-film forming technology. In the case of the ceramic multilayer board, it is desirable that the ceramic layers are made of a low-temperature sintered ceramic material, since silver or copper that has a low resistance value can be used as a member of the resonant circuit.

On the other hand, the power feeding circuit board may be a dielectric or magnetic single-layer board. In such a case, the capacitor pattern and/or inductor pattern are provided on the surface ofthe single-layer board. The material of the single-layer board may be resin or ceramic. The capacitance of the capacitor pattern may be formed between the flat electrodes provided on either side ofthe single-layer board, or may be formed between the electrodes disposed substantially parallel to each other on one surface of the single-layer board.

It is desirable that the power feeding circuit board is a rigid board. If the board is rigid, the frequency of a transmission signal can be maintained stable even when the wireless IC device is bonded to an article of any shape. Moreover, the wireless IC chip can be reliably mounted on a rigid board. On the other hand, it is desirable that the radiating plate is made of a flexible metal film. The flexible radiating plate allows the wireless IC device to be bonded to an article of any shape.

Furthermore, when the flexible metal film is retained in a flexible resin film, the wireless IC device can be easily manipulated. In particular, when all of the wireless IC chip, the power feeding circuit board, and the radiating plate are covered by the film, these components can be protected from the surrounding environment.

It is desirable that the electrical length of the radiating plate Is an integer multiple of a half wavelength of the resonant frequency, and in this case, the gain is maximized. However, since the frequency is substantially determined by the resonant circuit, it is not necessarily required that the electrical length of the radiating plate is an integer multiple of a half wavelength of the resonant frequency. This is a significant advantage as compared to a wireless IC device in which a radiating plate is an antenna device having a particular resonance frequency.

In addition, a variety of configuration may be used for the connection between the wireless IC chip and the power feeding circuit board. For example, the wireless IC chip may be provided with a chip-side electrode pattern, the powerfeeding circuit board may be provided with a first board-side electrode pattern, and the chip-side electrode pattern may be DC-connected to the first board-side electrode pattern. In this case, the connection can be made by soldering, an electroconductive resin, or a gold bump, for example.

Alternatively, the chip-side electrode pattern may be connected to the first board-side electrode pattern by capacitive coupling or magnetic coupling. When the connection is made by capacitive coupling or magnetic coupling, soldering or an electroconductive resin is not required, but an adhesive agent, such as resin, is used for bonding the chip-side electrode pattern to the first board-side electrode pattern. In this case, the chip-side electrode pattern and the first board-side electrode pattern need not be formed on the surface ofthe wireless IC chip and on the surface of the power feeding circuit board. For example, a resin film may be formed on the surface of the chip-side electrode pattern, or the first board-side electrode pattern may be formed on an inner layer of the multilayer board.

In the case of using capacitive coupling, it is desirable that the area of the first board-side electrode pattern is larger than the area of the chip-side electrode pattern. Even if the positional accuracy slightly varies at the time of mounting the wireless IC chip on the power feeding circuit board, variations in capacitance between the two electrode patterns can be greatly reduced. Moreover, it is difficult to form an electrode pattern having a large area on the small wireless IC chip. However, since the powerfeeding circuit board is relatively large, an electrode pattern having a large area can be formed without any problem.

In the case of using magnetic coupling, the accuracy required when the wireless IC chip is mounted on the power feeding circuit board is not critical, as compared with the case using capacitive coupling, which further facilitates the mounting operation. In addition, it is desirable that the chip-side electrode pattern and the first board-side electrode pattern are coil-shaped electrode patterns. In this case, a coil-shaped electrode pattern, such as a spiral pattern or a helical pattern, facilitates design. For a high frequency, a meandering electrode pattern is advantageous.

On the other hand, various types of configuration may be used for the connection between the power feeding circuit board and the radiating plate. For example, the powerfeeding circuit board may be provided with a second board-side electrode pattern, and the second board-side electrode pattern may be DC-connected to the radiating plate. In this case, connection can be made using soldering, an electroconductive resin, or a gold bump.

Alternatively, the second-board-side electrode pattern may be connected to the radiating plate using capacitive coupling or magnetic coupling. In the case of using capacitive coupling or magnetic coupling, it is not necessary to use soldering or electroconductive resin. The second board-side electrode pattern can be bonded to the radiating plate by an adhesive agent, such as resin. In this case, the second board-side electrode pattern need not be formed on the surface of the power feeding circuit board. For example, the second board-side electrode pattern may be formed on an inner layer of the multilayer board.

In the case of using magnetic coupling, it is desirable that the second board-side electrode pattern is a coil-shaped electrode pattern. A coil-shaped electrode pattern, such as a spiral pattern or a helical pattern, facilitates control of a magnetic flux, thereby facilitating design. For a high frequency, a meandering electrode pattern may be employed. In the case of using magnetic coupling, it is desirable that variations of magnetic flux that occur in the second board-side electrode pattern (coil-shaped electrode pattern) are not interrupted. For example, it is desirable that an opening is provided in the radiating plate. Thus, the transfer efficiency of signal energy is improved, and a frequency shift due to adhesion between the powerfeeding circuit board and the radiating plate can be reduced.

When the second board-side electrode pattern is a coil-shaped electrode pattern, the winding axis thereof may be disposed parallel or perpendicular to the radiating plate. In the latter case, it is desirable that the winding width of the coil-shaped electrode pattern gradually increases toward the radiating plate.

In the wireless IC devices according to the first and second inventions, if the radiating plate is a both-side-open (both-end-open) type radiating plate including a radiating section for exchanging transmission/reception signals with an external apparatus and a powerfeeding section for exchanging transmission/reception signals with the power feeding circuit (resonant circuit), antenna gain can be Improved by the radiating section. Thus, even a small powerfeeding circuit pattern can obtain a sufficient gain, the wireless IC device can operate at a sufficient distance from the reader/writer, and even a frequency band not less than the UHF band can be sufficient for use. Also, the resonant frequency is primarily determined by the powerfeeding circuit pattern, any shape of the radiating section can be freely used, the gain can be adjusted by the size of the radiating section, and the center frequency can be finely adjusted with the shape of the radiating section.

In addition, at least part of the power feeding section of the radiating plate is disposed within the projection plane of the powerfeeding circuit pattern, and the area of the power feeding section may be less than the area of the projection plane of the power feeding circuit pattern. As used herein, the term "projection plane" refers to a plane surrounded by the outline ofthe powerfeeding circuit pattern, and the term "area of the power feeding section" refers to the area of the metal section of the radiating plate. If the power feeding section of the radiating plate is coupled with the powerfeeding circuit pattern via a magnetic field, when the area of the power feeding section is less than the area of the projection plane of the power feeding circuit pattern, a portion that counteracts the magnetic flux emanating from the power feeding circuit pattern is reduced. Therefore, the transfer efficiency of signals is improved.

Furthermore, the powerfeeding section may be formed so as to cross the projection plane of the power feeding circuit pattern in the longitudinal direction thereof. For example, the power feeding section may be formed in a straight line. The radiating section of the radiating plate may be provided on both ends of the powerfeeding section or may be provided on one end of the power feeding section. When the radiating section is provided on both ends of the powerfeeding section, the capacitive coupling with the power feeding circuit pattern is increased. By providing the radiating section on only one end of the power feeding section, the magnetic coupling with the powerfeeding circuit pattern is strong, and therefore, the gain increases.

Still furthermore, multiple power feeding circuit patterns may be formed on the power feeding circuit board. In this case, it is desirable that the powerfeeding section of the radiating plate is disposed between adjacent pairs of projection planes ofthe multiple powerfeeding patterns. The power feeding section in the longitudinal direction thereof may be formed so as to cross the space between adjacent pairs of projection planes of the multiple powerfeeding circuit patterns. For example, the powerfeeding section in the longitudinal direction thereof may be formed in a straight line. By disposing the power feeding section between adjacent pairs of projection planes ofthe multiple powerfeeding patterns, the amount of electric power fed between the powerfeeding section and the power feeding circuit pattern increases.

The radiating plate may be formed in an x-y plane, and may include radiating sections extending in the x-axis direction and y-axis direction. Thus, circularly polarized waves can be received, and therefore, the antenna gain increases. In addition, the radiating plate may include radiating sections extending in the x-axis direction, y-axis direction, and z-axis direction, in an x-y-z space. By providing the radiating sections extending three-dimensionally, efficienttransmission and reception can be performed in any direction.

Yet still furthermore, the radiating section of the radiating plate may extend substantially perpendicular to the plane ofthe powerfeeding circuit pattern. That is, the power feeding section may be provided in a plane which is located at the top end of the needle-shaped radiating section and which is substantially perpendicular to the radiating section, and the powerfeeding section may be connected to the powerfeeding circuit pattern via an electric field or a magnetic field. Thus, the wireless IC device can be attached to an article by inserting the needle-shaped radiating section into the article.

Yet still furthermore, the power feeding section and the power feeding circuit pattern may be covered with a magnetic member. In this way, leakage of electromagnetic energy can be prevented, and the coupling between the powerfeeding section and the powerfeeding circuit pattern is improved, thus increasing the antenna gain.

According to a third invention, a component for a wireless IC device includes a wireless IC chip and a power feeding circuit board that is connected to the wireless IC chip and that incorporates a powerfeeding circuit. The powerfeed ing circuit includes a resonant circuit having a predetermined resonant frequency.

According to a fourth Invention, a component for a wireless IC device includes a wireless IC chip and a powerfeeding circuit board having the wireless IC chip mounted thereon and incorporating a power feeding circuit. The powerfeeding circuit includes a resonant circuit it having a predetermined resonant frequency.

### Advantages

According to the first and second inventions, the wireless IC chip can be highly precisely mounted on the wiring board or the power feeding circuit board. In addition, the frequency of a transmission signal and a reception signal is determined by the power feeding circuit disposed on the power feeding circuit board. Therefore, even when the wireless IC device is curled or is inserted between dielectric materials, the frequency characteristic does not vary, and therefore, a stable frequency characteristic can be obtained.

According to the third and fourth inventions, the wireless IC devices according to the first and second inventions can be optimally configured.

### Brief Description of the Drawings

Fig. 1 is a perspective view of a wireless IC device according to a first embodiment of the present invention;
Fig. 2 is a cross-sectional view of the wireless IC device according to the first embodiment;
Fig. 3 is an equivalent circuit diagram of the wireless IC device according to the first embodiment;
Fig. 4 is an exploded perspective view of a power feeding circuit board according to the first embodiment;
Figs. 5(A) and 5(B) illustrate a connection configuration between the wireless IC chip and the power feeding circuit board;
Fig. 6 is a perspective view of a first modification of a radiating plate;
Fig. 7 is a perspective view of a second modification of the radiating plate;
Fig. 8 is a plan view of a wireless IC device according to a second embodiment of the present invention;
Figs. 9(A) and 9(B) illustrate a wireless IC device according to a third embodiment of the present invention, where Fig. 9 (A) is a plan view when the wireless IC device is developed and Fig. 9(B) is a perspective view when the wireless IC device Is In use;
Fig. 10 is a perspective view of a wireless IC device according to a fourth embodiment of the present invention;
Fig. 11 is a perspective view of a wireless IC device according to a fifth embodiment of the present invention;
Fig. 12 is a cross-sectional view of a wireless IC device according to a sixth embodiment of the present invention;
Fig. 13 is an equivalent circuit diagram of a wireless IC device according to a seventh embodiment of the present invention;
Fig. 14 is an equivalent circuit diagram of a wireless IC device according to an eighth embodiment of the present invention;
Fig. 15 is an equivalent circuit diagram of a wireless IC device according to a ninth embodiment of the present invention;
Fig. 16 is a cross-sectional view of a wireless IC device according to a tenth embodiment of the present invention;
Fig.17 is an equivalentcircuitdiagram of the wireless IC device according to the tenth embodiment of the present invention;
Fig. 18 is an exploded perspective view of a power feeding circuit board according to the tenth embodiment;
Fig. 19 is an equivalent circuit diagram of a wireless IC device according to an eleventh embodiment of the present invention;
Fig. 20 is an equivalent circuit diagram of a wireless IC device according to a twelfth embodiment of the present invention;
Fig. 21 Is an exploded perspective view of a power feeding circuit board according to the twelfth embodiment;
Fig. 22 is a perspective view of a wireless IC device according to a thirteenth embodiment of the present invention;
Fig. 23 is a cross-sectional view of a wireless IC device according to a fourteenth embodiment of the present invention;
Fig. 24 is an exploded perspective view of a power feeding circuit board according to the fourteenth embodiment;
Fig. 25 is an equivalent circuit diagram of a wireless IC device according to a fifteenth embodiment of the present invention;
Fig. 26 is an exploded perspective view of a power feeding circuit board according to the fifteenth embodiment;
Fig. 27 is an equivalent circuit diagram of a wireless IC device according to a sixteenth embodiment of the present invention;
Fig. 28 is an exploded perspective view of a power feeding circuit board according to the sixteenth embodiment;
Fig. 29 is an equivalent circuit diagram of a wireless IC device according to a seventeenth embodiment of the present invention;
Fig. 30 is an exploded perspective view of a power feeding circuit board according to the seventeenth embodiment;
Fig. 31 is a graph illustrating a reflection characteristic according to the seventeenth embodiment;
Fig. 32 is an equivalent circuit diagram of a wireless IC device according to an eighteenth embodiment of the present invention;
Fig. 33 is an exploded perspective view of a power feeding circuit board according to the eighteenth embodiment;
Figs. 34(A) and 34(B) illustrate a wireless IC chip according to the eighteenth embodiment, where Fig. 34(A) is a bottom view and Fig. 34(B) is an enlarged cross-sectional view;
Fig. 35 is an equivalent circuit diagram of a wireless IC device according to a nineteenth embodiment of the present invention;
Fig. 36 is an exploded perspective view of a power feeding circuit board according to the nineteenth embodiment;
Fig. 37 is an exploded perspective view of a wireless IC device according to a twentieth embodiment of the present invention;
Fig. 38 is a bottom view of a power feeding circuit board having a wireless IC device mounted thereon according to the twentieth embodiment;
Fig. 39 is a side view of the wireless IC device according to the twentieth embodiment;
Fig. 40 is a side view of a wireless IC device according to a first modification of the twentieth embodiment;
Fig. 41 is a perspective view of the modification shown in Fig. 40 in a first configuration;
Fig. 42 is a perspective view of the modification shown in Fig. 40 in a second configuration;
Fig. 43 is an exploded perspective view of a wireless IC device according to a twenty-first embodiment of the present invention;
Fig. 44 is an equivalent circuit diagram of a wireless IC device according to a twenty-second embodiment of the present invention;
Fig. 45 is an exploded perspective view of a power feeding circuit board according to the twenty-second embodiment;
Fig. 46 is an exploded perspective view of a power feeding circuit board of a wireless IC device according to a twenty-third embodiment of the present invention;
Fig. 47 is an equivalent circuit diagram of a wireless IC device according to a twenty-fourth embodiment of the present invention;
Fig. 48 is a perspective view of a power feeding circuit board according to the twenty-fourth embodiment;
Fig. 49 is an equivalent circuit diagram of a wireless IC device according to a twenty-fifth embodiment of the present invention;
Fig. 50 is a perspective view of a power feeding circuit board according to the twenty-fifth embodiment; Fig. 51 is an equivalent circuit diagram of a wireless IC device according to a twenty-sixth embodiment of the present invention;
Fig. 52 is a perspective view of a power feeding circuit board according to the twenty-sixth embodiment;
Fig. 53 is an equivalent circuit diagram of a wireless IC device according to a twenty-seventh embodiment of the present invention;
Fig. 54 is a perspective view of a power feeding circuit board according to the twenty-seventh embodiment;
Fig. 55 is a cross-sectional view of a wireless IC device according to a twenty-eighth embodiment of the present invention;
Fig. 56 is a cross-sectional view of a wireless IC device according to a twenty-ninth embodiment of the present invention;
Fig. 57 is a perspective view of a wireless IC device according to a thirtieth embodiment of the present invention;
Fig. 58 is a perspective view of a wireless IC device according to a thirty-first embodiment of the present invention;
Fig. 59 is a plan view of a first example of an existing wireless IC device; and
Fig. 60 is a plan view of a second example of an existing wireless IC device;

### Best Mode for Carrying Out the Invention

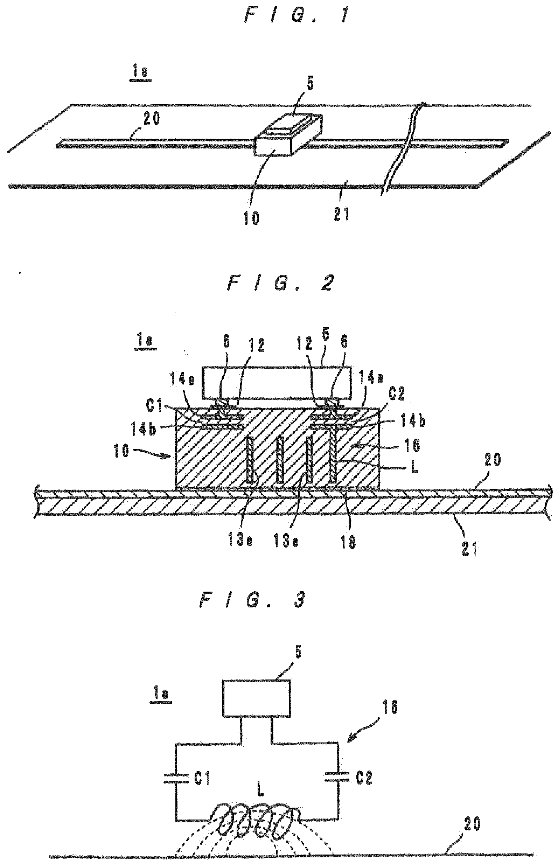

Embodiments of a wireless IC device and a component for a wireless IC device according to the present Invention are described below with reference to the accompanying drawings. In the following embodiments, the same reference numerals indicate similar components or parts, and redundant descriptions will be omitted. First Embodiment (refer to Figs. 1 to 7)

According to a first embodiment, a wireless IC device 1 a is of a monopole type. As shown in Figs. 1 and 2, the wireless IC device 1a includes a wireless IC chip 5, a power feeding circuit board 10 having the wireless IC chip 5 mounted on the upper surface thereof, and a radiating plate 20 having the power feeding circuit board 10 bonded thereon. The wireless IC chip 5 includes a clock circuit, a logic circuit and a memory circuit, and stores necessary information. The wireless IC chip 5 is directly DC-connected to a power feeding circuit 16 provided in the power feeding circuit board 10.

The power feeding circuit 16 supplies a transmission signal having a predetermined frequency to the radiating plate 20 and/or selects a reception signal having a predetermined frequency from signals received by the radiating plate 20 so as to supply the selected signal to the wireless IC chip 5. The power feeding circuit 16 includes a resonance circuit that resonates with the frequency of the transmission/reception signal.

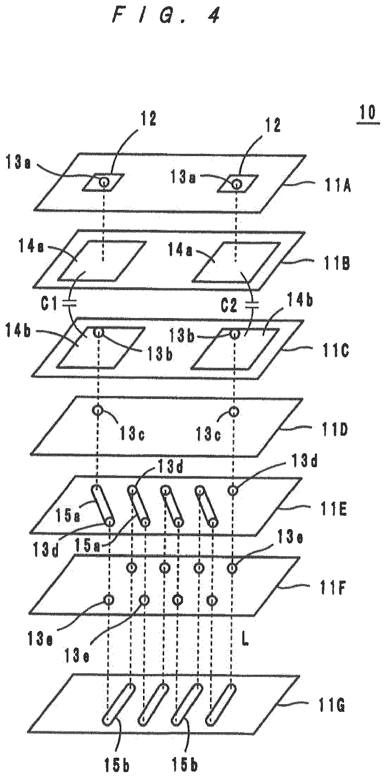

As shown in Figs. 2 and 3, the power feeding circuit board 10 includes the power feeding circuit 16 of a lumped-constant LC series type having a helical inductance element L and capacitance elements C1 and C2. More specifically, as shown in Fig. 4, ceramic sheets 11 A to 11G made of a dielectric material are laminated, pressed, and sintered so as to form the power feeding circuit board 10. The ceramic sheet 11 A includes connection electrodes 12 and via-hole conductors 13a formed therein. The ceramic sheet 11 B includes capacitor electrodes 14a formed therein. The ceramic sheet 11 C includes capacitor electrodes 14b and via-hole conductors 13b formed therein. The ceramic sheet 11 D includes via-hole conductors 13c formed therein. The ceramic sheet 11E includes conductor patterns 15a and via-hole conductors 13d formed therein. The (at least one) ceramic sheet 11F includes via-hole conductors 13e formed therein. The ceramic sheet 11 G includes conductor patterns 15b formed therein. Each of the ceramic sheets 11 A to 11 G may be made of a magnetic ceramic material. The powerfeeding circuit board 10 can be easily manufactured using a known multilayer fabrication method, such as a sheet lamination method or a thick film printing method.

By laminating the ceramic sheets 11A to 11 G, the inductance element L and the capacitance elements C1 and C2 are formed. The inductance element Lfollows a helical path about a winding axis which is parallel to the radiating plate 20. In the capacitance elements C1 and C2, the capacitor electrodes 14b are connected to either end of the inductance element L. In addition, each of the capacitor electrodes 14a is connected to one of the connection electrodes 12 via the via-hole conductor 13a. Furthermore, the connection electrode 12 that forms an electrode pattern on the board side Is DC-connected to an electrode pattern (not shown) of the wireless IC chip 5 on the chip side via a solder bump 6.

That is, a transmission signal is fed from the inductance element L, which Is a coll-shaped electrode pattern in the power feeding circuit 16, to the radiating plate 20 via a magnetic field. A reception signal is fed from the radiating plate 20 to the inductance element L via a magnetic field. Accordingly, it is desirable that, among the inductance element L and the capacitance elements C1 and C2 that form a resonance circuit, the inductance element L is disposed so as to be closer to the radiating plate 20.

The radiating plate 20 is a long rectangular plate made of a nonmagnetic material, such as an aluminum foil or a copper foil. That is, the radiating plate 20 is a both-end-open type metal plate. The radiating plate 20 is formed on a flexible insulating resin film 21, such as a PET. The lower surface ofthe powerfeeding circuit board 10 is bonded to the radiating plate 20 with an insulating adhesive layer composed of an adhesive agent 18 in-between.

For example, the thickness of the wireless IC chip 5 is in the range of 50 µm to 100 µm. The thickness of the solder bump 6 is about 20 µm. The thickness of the power feeding circuit board 10 is in the range of 200 µm to 500 µm. The thickness of the adhesive agent 18 is in the range of 0.1 µm to 10 µm. The thickness of the radiating plate 20 is in the range of 1 µm to 50 µm. The thickness of the film 21 is in the range of 10 µm to 100 µm. The size (area) of the wireless IC chip 5 can be varied, such as 0.4 mm by 0.4 mm or 0.9 mm by 0.8 mm. The size (area) of the powerfeeding circuit board 10 can be from the same size as the wireless IC chip 5 to about 3 mm by 3 mm.

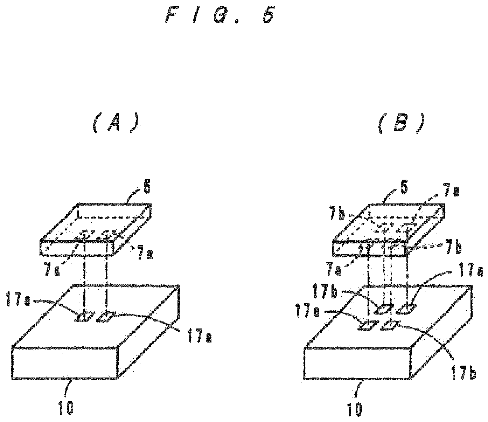

Fig. 5 illustrates connection arrangements between the wireless IC chip 5 and the powerfeeding circuit board 10. In Fig. 5A, a pair of antenna (balanced) terminals 7a and 17a are provided on the lower surface of the wireless IC chip 5 and the upper surface of the power feeding circuit board 10, respectively. In contrast, Fig. 5B illustrates another connection arrangement. In Fig. 5B, ground terminals 7b and 17b are provided on the lower surface of the wireless IC chip 5 and the upper surface of the power feeding circuit board 10, respectively, in addition to the pair of antenna (balanced) terminals 7a and 17a. The ground terminal 17b of the power feeding circuit board 10 is terminated and is not connected to any other elements of the power feeding circuit board 10.

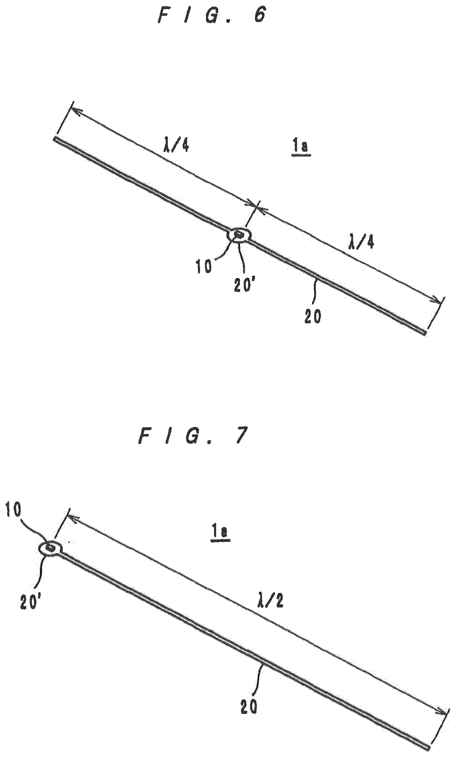

In addition, as shown in Figs. 6 and 7, it is desirable that the radiating plate 20 has a slender shape, and an area 20' of the radiating plate 20 to which the powerfeeding circuit board 10 is bonded is greater than the board 10. In this way, precise positioning is not required when the power feeding circuit board 10 is bonded to the radiating plate 20a, and stable electrical characteristics can be obtained.

Fig.3 illustrates an equivalent circuit of the wireless IC device 1 a. The wireless IC device 1a receives a high-frequency signal (e.g., a signal in a UHF band) radiated from a reader/writer (not shown) at the radiating plate 20. By resonating the power feeding circuit 16 (the LC series resonance circuit composed of the inductance element L and the capacitance elements C1 and C2) that is mainly magnetically coupled with the radiating plate 20, the wireless IC device 1a supplies the wireless IC chip 5 with only a reception signal in a predetermined frequency band. Meanwhile, the wireless IC device 1a extracts predetermined energy from the reception signal, and by using this energy as a driving source, the wireless IC device 1 a matches the information stored in the wireless IC chip 5 with a predetermined frequency at the power feeding circuit 16. Thereafter, the wireless IC device 1 a propagates a transmission signal from the inductance element L of the power feeding circuit 16 to the radiating plate 20 via magnetic coupling. The radiating plate 20 transmits the transmission signal to the reader/writer.

The coupling of the power feeding circuit 16 with the radiating plate 20 is mainly achieved via a magnetic field. However, in addition to the magnetic coupling, coupling via an electric field may be present (electromagnetic coupling).

According to the first embodiment, In the wireless IC device 1a, the wireless IC chip 5 is directly DC-connected to the power feeding circuit board 10, which incorporates the power feeding circuit 16. The power feeding circuit board 10 has substantially the same area as the wireless IC chip 5, and is rigid. Accordingly, as compared with the existing case where the wireless IC chip 5 is mounted on a flexible film having a large area, the wireless IC chip 5 can be precisely positioned and mounted on the power feeding circuit board 10. Furthermore, the power feeding circuit board 10 is made of a ceramic material and has an excellent resistance to heat, and therefore, the wireless IC chip 5 can be soldered to the power feeding circuit board 10. That is, the wireless IC chip 5 can be bonded to the power feeding circuit board 10 without using an expensive ultrasonic bonding method that has been conventionally adopted. Thus, the cost can be reduced, and there is no danger that the wireless IC chip 5 may be damaged due to pressure applied during ultrasonic bonding. Furthermore, a self-alignment effect provided by solder reflow can be used.

In the power feeding circuit 16, the resonance frequency properties are determined by the resonance circuit including the inductance element L and the capacitance elements C1 and C2. The resonance frequency of a signal radiated from the radiating plate 20 is substantially the same as the self-resonance frequency of the power feeding circuit 16. The maximum gain of the signal is substantially determined by at least one of the size and shape of the power feeding circuit 16 and the distance and medium between the power feeding circuit 16 and the radiating plate 20. More specifically, according to the first embodiment, the electrical length of the radiating plate 20 is set to 1/2 of the resonance frequency X. However, the electrical length of the radiating plate 20 need not be an integer multiple of λ/2. That is, according to the present invention, the frequency of a signal radiated from the radiating plate 20 is substantially determined by the resonance frequency of the resonance circuit (the power feeding circuit 16). Therefore, the frequency characteristics are not substantially dependent on the electrical length of the radiating plate 20. It is desirable that the electrical length of the radiating plate 20 is an integer multiple of λ/2 so as to maximize the gain.

As described above, the resonance frequency characteristics of the power feeding circuit 16 are determined by the resonance circuit composed of the inductance element L and the capacitance elements C1 and C2 incorporated in the power feeding circuit board 10. Accordingly, even when the wireless IC device 1a is inserted into a book, the resonance frequency characteristics do not change. In addition, even when the wireless IC device 1a is curled to change the shape or the size of the radiating plate 20, the resonance frequency characteristics do not change. Furthermore, since the coil-shaped electrode pattern that forms the inductance element L is disposed so that the winding axis thereof is parallel to the radiating plate 20, the center frequency does not advantageously vary. Still furthermore, since the capacitance elements C1 and C2 are disposed downstream of the wireless IC chip 5, a low-frequency surge is prevented by the capacitance elements C1 and C2. Thus, the wireless IC chip 5 can be protected from a surge.

In addition, since the power feeding circuit board 10 is a rigid multilayer board, the wireless IC chip 5 can be easily soldered. Furthermore, the radiating plate 20 is formed from a flexible metal film supported by the flexible film 21. Therefore, the radiating plate 20 can be easily bonded to, for example, a cylindrical member, such as a PET bottle or a soft bag made of a plastic film.

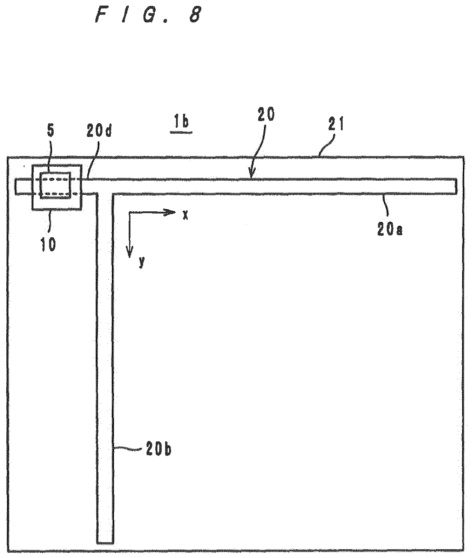

According to the present invention, the resonance circuit may function as a matching circuit for matching the impedance of the wireless IC chip with the impedance of the radiating plate. Alternatively, the power feeding circuit board may further include a matching circuit that includes an inductance element and a capacitance element and that is provided separately from the resonance circuit. In general, when the resonance circuit includes the function of a matching circuit, the design of the resonance circuit is complicated. However, if a matching circuit is provided separately from the resonance circuit, the resonance circuit and the matching circuit can be designed independently. Second Embodiment (refer to Fig. 8)

According to a second embodiment, as shown in Fig. 8, in a wireless IC device 1 b, the radiating plate 20 branches into two parts at an angle of 90°. That is, the radiating plate 20 Includes a radiating section 20a that extends in an x-axis direction and a radiating section 20b that extends in a y-axis direction in an x-y plane. Further, the radiating plate 20 has an extension of the radiating section 20a, which serves as a power feeding section 20d. On the power feeding section 20d, a power feeding circuit board 10 having a wireless IC chip 5 mounted thereon is bonded.

The internal structure of the power feeding circuit board 10 is similar to that of the first embodiment. The operation and advantages of the second embodiment are the same as those of the first embodiment. In addition, since the radiating sections 20a and 20b extend in the x-axis direction and the y-axis direction, respectively, the radiating plate 20 can receive circularly polarized waves. Accordingly, the antenna gain is improved.

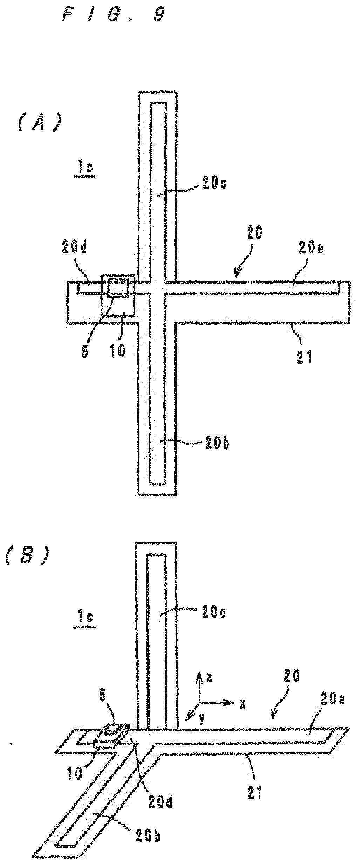

### Third Embodiment (refer to Fig. 9)

According to a third embodiment, as shown in Figs. 9(A) and 9(B), in a wireless IC device 1 c, a radiating plate 20 includes radiating sections 20a, 20b, and 20c that extend in an x-axis direction, a y-axis direction, and az-axis direction, respectively, in an x-y-z space. A power feeding circuit board 10 having a wireless IC chip 5 mounted thereon is bonded onto a power feeding section 20d which is an extension of the radiating section 20a.

For example, the wireless IC device 1c can be mounted at a corner of a box-shaped article. Since the radiating sections 20a, 20b, and 20c are disposed three-dimensionally, the directivity of the antenna can be eliminated. Thus, in any direction, efficient transmission and reception can be performed. In addition, the operation and advantages of the wireless IC device 1 c are the same as those of the first embodiment.

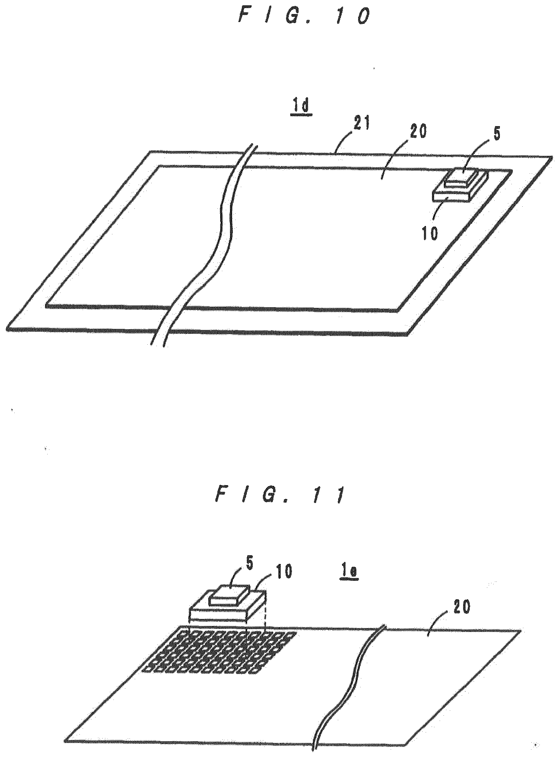

### Fourth Embodiment (refer to Fig. 10)

According to a fourth embodiment, as shown in Fig. 10, in a wireless IC device 1 d, the radiating plate 20 having a large area and made of an aluminum foil is formed on an insulating flexible plastic film 21 having a large area. A power feeding circuit board 10 having a wireless IC chip 5 mounted thereon is bonded to the radiating plate 20 at any location.

The other structure of the wireless IC device 1 d, that is, the internal structure of the power feeding circuit board 10 is similar to that of the first embodiment. Accordingly, the operation and advantages of the fourth embodiment are the same as those of the first embodiment. In addition, the fourth embodiment has an advantage in that high-precision positioning is not required when the power feeding circuit board 10 is bonded to the radiating plate 20.

### Fifth Embodiment (refer to Fig. 11)

According to a fifth embodiment, as shown in Fig. 11, in a wireless IC device 1 e, the radiating plate 20 having a large area and made of an aluminum foil is formed in a mesh. The entire radiating plate 20 may be a mesh, or alternatively, a part of the radiating plate 20 may be a mesh.

The other structures of the wireless IC device 1 e are similar to those of the fourth embodiment. Accordingly, high-precision positioning is not required when the power feeding circuit board 10 is bonded to the radiating plate 20. In addition, since the magnetic flux of the coil-shaped electrode pattern passes through the openings of the mesh, a change (a decrease) in magnetic flux emanating from the powerfeeding circuit board 10 is reduced. Thus, more magnetic fluxes can pass through the radiating plate 20, and the propagation efficiency of signal energy is improved. In addition, a shift of the frequency caused by bonding can be reduced.

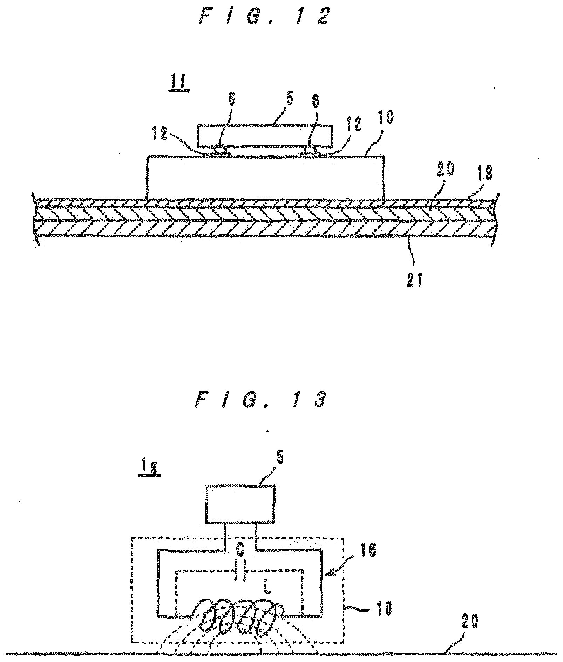

### Sixth Embodiment (refer to Fig. 12)

According to a sixth embodiment, as shown in Fig. 12, in a wireless IC device 1f, an adhesive agent 18 is applied to the entire surface of the film 21 to which the power feeding circuit board 10 is bonded via the radiating plate 20. The adhesive agent 18 enables the wireless IC device 1 f to be bondedto an arbitrary portion of an article.

The other structure of the wireless IC device 1f, that is, the internal structure of the power feeding circuit board 10 is similar to that of the first embodiment. Accordingly, the operation and advantages of the sixth embodiment are the same as those of the first embodiment.

### Seventh Embodiment (refer to Fig. 13)

According to a seventh embodiment, as shown by an equivalent circuit in Fig. 13, a wireless IC device 1g has a power feeding circuit board 10 incorporating an inductance element L that serves as the power feeding circuit 16 and that has a coil-shaped electrode pattern. A capacitance element C that forms an LC parallel resonance circuit is provided in the form of a floating capacitance (distributed-constant-type capacitance) between the conductor patterns of the inductance element L.

That is, when even one coil-shaped electrode pattern has self-resonance, the coil-shaped electrode pattern can function as an LC parallel resonance circuit by using the L component of the coil-shaped electrode pattern itself and the C component generated as a line floating capacitance, and a power feeding circuit 16 can be achieved. Accordingly, the wireless IC device 1g receives a high-frequency signal (e.g., a signal in a UHF band) radiated from a reader/writer (not shown) at the radiating plate 20. By resonating the powerfeeding circuit it 16 (the LC parallel resonance circuit composed of the inductance element L and the capacitance element C) that is mainly magnetically coupled with the radiating plate 20, the wireless IC device 1 g supplies the wireless IC chip 5 with only a reception signal in a predetermined frequency band. Meanwhile, the wireless IC device 1g extracts predetermined energy from the reception signal, and by using this energy as a driving source, the wireless IC device 1 g matches the information stored in the wireless IC chip 5 with a predetermined frequency at the power feeding circuit 16. Thereafter, the wireless IC device 1 g propagates a transmission signal from the inductance element L of the power feeding circuit 16 to the radiating plate 20 via magnetic coupling. The radiating plate 20 transmits the transmission signal to the reader/writer.

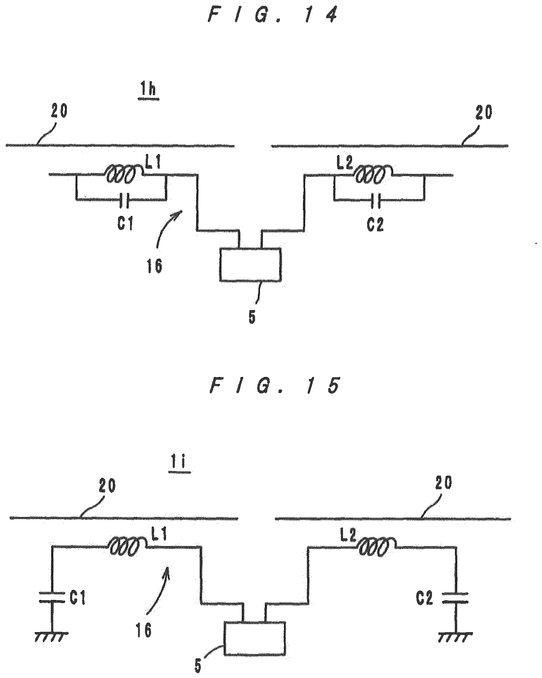

### Eighth Embodiment (refer to Fig. 14)

According to an eighth embodiment, as shown by an equivalent circuit in Fig. 14, a wireless IC device 1h includes a dipole-type power feeding circuit 16 and radiating plates 20. The powerfeeding circuit 16 includes two LC parallel resonance circuits disposed in a power feeding circuit board. An inductance element L1 and a capacitance element C1 are connected to a first port side of the wireless IC chip 5. An inductance element L2 and a capacitance element C2 are connected to a second port side of the wireless IC chip 5. The inductance element L1 and the capacitance element C1 face one of the radiating plates 20. The Inductance element L2 and the capacitance element C2 face the other radiating plate 20. An end of the inductance element L1 and the capacitance element C1 is open. Note that the first port and the second port form the I/O ports of a differential circuit.

The operation and advantages of the eighth embodiment are basically similar to those of the first embodiment. That is, the wireless IC device 1 h receives a high-frequency signal (e.g., a signal in a UHF band) radiated from a reader/writer (not shown) at the radiating plates 20. By resonating the powerfeeding circuit 16 (the LC parallel resonance circuit composed ofthe inductance element L1 and the capacitance element C1, and the LC parallel resonance circuit composed of the inductance element L2 and the capacitance element C2) that is mainly magnetically coupled with the radiating plates 20, the wireless IC device 1 h supplies the wireless IC chip 5 with only a reception signal in a predetermined frequency band. Meanwhile, the wireless IC device 1 h extracts predetermined energy from the reception signal, and by using this energy as a driving source, the wireless IC device 1 h matches the information stored in the wireless IC chip 5 with a predetermined frequency at the power feeding circuit 16. Thereafter, the wireless IC device 1h propagates a transmission signal from the inductance elements L1 and L2 of the power feeding circuit 16 to the radiating plates 20 via magnetic coupling. The radiating plates 20 transmit the transmission signal to the reader/ writer.

### Ninth Embodiment (refer to Fig. 15)

According to a ninth embodiment, as shown by an equivalent circuit in Fig. 15, a wireless IC device li includes a dipole-type powerfeeding circuit 16 and radiating plates 20. The power feeding circuit 16 includes two LC series resonance circuits disposed in a power feeding circuit board. An inductance element L1 faces one ofthe radiating plates 20, and an Inductance element L2 faces the other radiating plate 20. Capacitance elements C1 and C2 are grounded.

The operation and advantages of the ninth embodiment are basically similar to those of the first embodiment. That is, the wireless IC device li receives a high-frequency signal (e.g., a signal in a UHF band) radiated from a reader/writer (not shown) at the radiating plates 20. By resonating the powerfeeding circuit 16 (the LC series resonance circuit composed of the inductance element L1 and the capacitance element C1, and the LC series resonance circuit composed of the inductance element L2 and the capacitance element C2) that is mainly magnetically coupled with the radiating plates 20, the wireless IC device li supplies the wireless IC chip 5 with only a reception signal in a predetermined frequency band. Meanwhile, the wireless IC device li extracts predetermined energy from the reception signal, and by using this energy as a driving source, the wireless IC device It matches the Information stored in the wireless IC chip 5 with a predetermined frequency at the power feeding circuit 16. Thereafter, the wireless IC device li propagates a transmission signal from the inductance elements L1 and L2 of the power feeding circuit 16 to the radiating plates 20 via magnetic coupling. The radiating plates 20 transmit the transmission signal to the reader/writer.

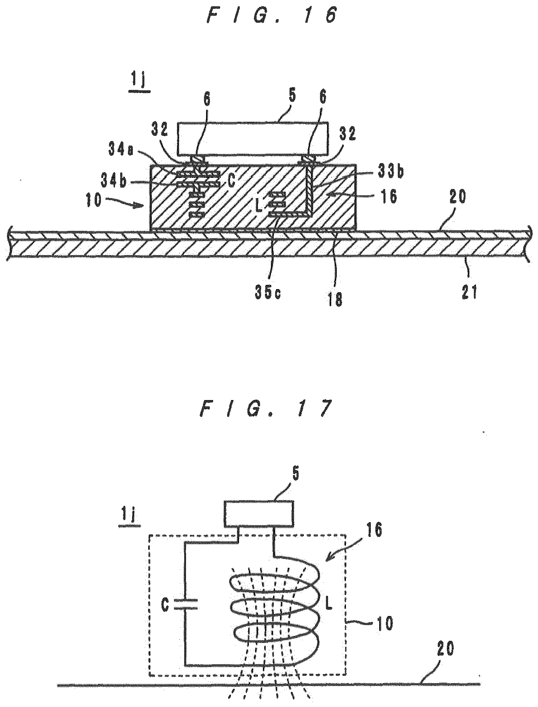

### Tenth Embodiment (refer to Figs. 16 to 18)

According to a tenth embodiment, as shown in Fig. 16, a wireless IC device 1j is of a monopole type. A powerfeeding circuit 16 includes an LC series resonance circuit, which is composed of an inductance element L and a capacitance element C, incorporated in a power feeding circuit board 10. As shown in Fig. 17, a coil-shaped electrode pattern that forms the inductance element L has a winding axis that is perpendicular to the radiating plate 20. The powerfeeding circuit 16 is mainly magnetically coupled with the radiating plate 20.

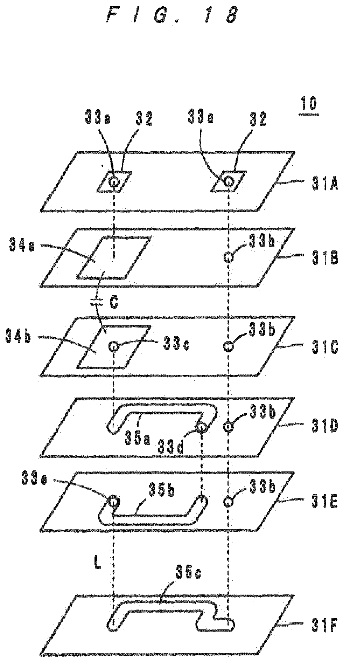

More specifically, as shown in Fig. 18, ceramic sheets 31 A to 31F made of a dielectric material are laminated, pressed, and sintered so as to form the power feeding circuit board 10. The ceramic sheet 31A includes connection electrodes 32 and via-hole conductors 33a formed therein. The ceramic sheet 31 B includes a capacitor electrode 34a and a via-hole conductor 33b formed therein. The ceramic sheet 31C includes a capacitor electrode 34b, a via-hole conductor 33c, and the via-hole conductor 33b formed therein. The (at least one) ceramic sheet 31 D Includes a conductor pattern 35a, a via-hole conductor 33d, and the via-hole conductor 33b formed therein. The (at least one) ceramic sheet 31 E includes a conductor pattern 35b, a via-hole conductor 33e, and the via-hole conductor 33b formed therein. The ceramic sheet 31 F Includes a conductor pattern 35c formed therein.

By laminating the ceramic sheets 31A to 31 F, the power feeding circuit 16 including the LC series resonance circuit can be obtained. In the LC series resonance circuit, the capacitance element C is connected in series to the inductance element L having a helical winding axis which is parallel to the radiating plate 20. The capacitor electrode 34a is connected to one of the connection electrodes 32 via the via-hole conductor 33a. In addition, the capacitor electrode 34a is connected to the wireless IC chip 5 via a solder bump 6. One end of the inductance element L is connected to the other connection electrode 32 via the via-hole conductor 33b and is further connected to the wireless IC chip 5 via a solder bump 6.

The operation and advantage of the tenth embodiment are basically similar to those of the first embodiment. That is, the wireless IC device 1j receives a high-frequency signal (e.g., a signal in a UHF band) radiated from a reader/writer (not shown) at the radiating plate 20. By resonating the power feeding circuit 16 (the LC series resonance circuit composed of the inductance element L and the capacitance element C) that is mainly magnetically coupled with the radiating plate 20, the wireless IC device 1j supplies the wireless IC chip 5 with only a reception signal in a predetermined frequency band. Meanwhile, the wireless IC device 1j extracts predetermined energy from the reception signal, and by using this energy as a driving source, the wireless IC device 1j matches the information stored in the wireless IC chip 5 with a predetermined frequency at the powerfeeding circuit 16. Thereafter, the wireless IC device 1j propagates a transmission signal from the inductance element L of the power feeding circuit 16 to the radiating plate 20 via magnetic coupling. The radiating plate 20 transmits the transmission signal to the reader/writer.

In particular, according to the tenth embodiment, since the coil-shaped electrode pattern has a winding axis perpendicular to the radiating plate 20, the magnetic flux component arriving at the radiating plate 20 increases. Therefore, the propagation efficiency of signal energy improves, and the gain increases.

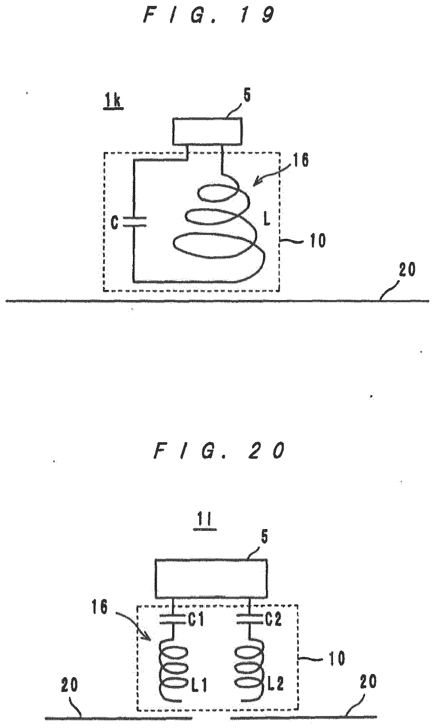

### Eleventh Embodiment (refer to Fig. 19)

According to an eleventh embodiment, as shown by an equivalent circuit in Fig. 19, in a wireless IC device 1 k, the winding width (coil diameter) of the coil-shaped electrode pattern of the inductance element L described in the tenth embodiment gradually increases towards the radiating plate 20. The other structure is similar to that of the tenth embodiment.

The operation and advantages of the eleventh embodiment are similar to those of the tenth embodiment. In addition, since the winding width (coli diameter) of the coil-shaped electrode pattern of the inductance element L gradually increases towards the radiating plate 20, the propagation efficiency of signal energy is Improved.

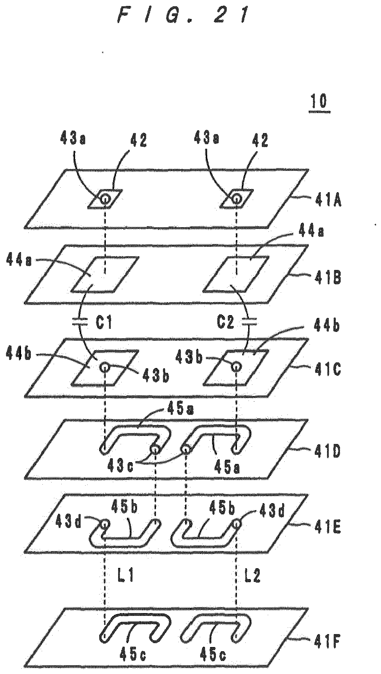

### Twelfth Embodiment (refer to Figs. 20 and 21)

According to a twelfth embodiment, as shown by an equivalent circuit in Fig. 20, a wireless IC device 11 is of a dipole type. The wireless IC device 11 includes a power feeding circuit 16 composed of two LC series resonance circuits disposed in a power feeding circuit board 10.

More specifically, as shown in Fig. 21, ceramic sheets 41 A to 41F made of a dielectric material are laminated, pressed, and sintered so as to form the power feeding circuit board 10. The ceramic sheet 41A includes connection electrodes 42 and via-hole conductors 43a formed therein. The ceramic sheet 41 B includes capacitor electrodes 44a formed therein. The ceramic sheet 41C includes capacitor electrodes 44b and via-hole conductors 43b formed therein. The (at least one) ceramic sheet 41 D includes conductor patterns 45a and via-hole conductors 43c formed therein. The (at least one) ceramic sheet 41E includes conductor patterns 45b and via-hole conductors 43d formed therein. The ceramic sheet 41F includes conductor patterns 45c formed therein.

By laminating the ceramic sheets 41A to 41 F, the power feeding circuit 16 including the LC series resonance circuit can be obtained. In the LC series resonance circuit, capacitance elements C1 and C2 are connected in seriesto inductance elements L1 and L2 having helical winding axes which are perpendicular to the radiating plate 20, respectively. The capacitor electrodes 44a are connected to the connection electrodes 42 via the via-hole conductors 43a. In addition, the capacitor electrodes 44a are connected to the wireless IC chip 5 via solder bumps 6.

The operation and advantages of the twelfth embodiment are basically similar to those of the first embodiment. That is, the wireless IC device 11 receives a high-frequency signal (e.g., a signal in a UHF band) radiated from a reader/writer (not shown) at the radiating plates 20. By resonating the powerfeeding circuit 16 (the LC series resonance circuit composed of the inductance element L1 and the capacitance element C1, and the LC series resonance circuit composed of the inductance element L2 and the capacitance element C2) that is mainly magnetically coupled with the radiating plates 20, the wireless IC device 11 supplies the wireless IC chip 5 with only a reception signal in a predetermined frequency band. Meanwhile, the wireless IC device 11 extracts predetermined energy from the reception signal, and by using this energy as a driving source, the wireless IC device 11 matches the information stored in the wireless IC chip 5 with a predetermined frequency at the power feeding circuit 16. Thereafter, the wireless IC device 11 propagates a transmission signal from the inductance elements L1 and L2 of the power feeding circuit 16 to the radiating plates 20 via magnetic coupling. The radiating plates 20 transmit the transmission signal to the reader/ writer.

Furthermore, the capacitance elements C1 and C2 are disposed downstream of the wireless IC chip 5. The capacitance element C1 is disposed between the wireless IC chip 5 and the inductance element L1, and the capacitance element C2 is disposed between the wireless IC chip 5 and the inductance element L2. Accordingly, surge resistance is improved. Since surge Is a low-frequency electrical current up to 200 MHz, the surge can be removed by the capacitance elements C1 and C2. Thus, surge breakdown of the wireless IC chip 5 is prevented.

Note that, according to the twelfth embodiment, the resonance circuit composed of the capacitance element C1 and the inductance element L1 is not coupled to the resonance circuit composed of the capacitance element C2 and the inductance element L2.

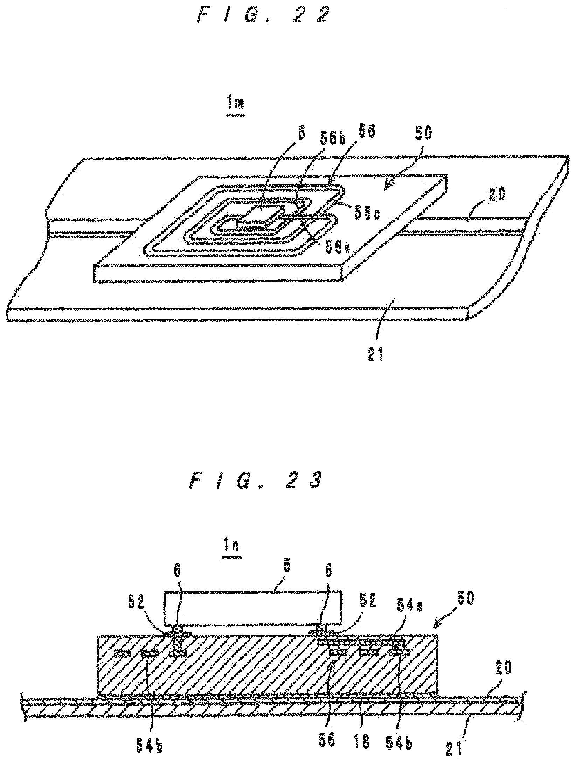

### Thirteenth Embodiment (refer to Fig. 22)

According to a thirteenth embodiment, as shown in Fig. 22, in a wireless IC device 1 m, a power feeding circuit 56 Including a coil-shaped electrode pattern, that is, a spiral inductance element is formed on the surface of a power feeding circuit board 50, which is a rigid single-layer board made of ceramic or a heat-resisting resin. Either end of the power feeding circuit 56 is directly connected to a wireless IC chip 5 via a solder bump. The power feeding circuit board 50 is bonded to a film 21 that holds a radiating plate 20 by an adhesive agent. In addition, a conductor pattern 56a is separated from conductor patterns 56b and 56c, which cross the conductor pattern 56a, by an insulating film (not shown).

According to the thirteenth embodiment, the power feeding circuit 56 forms an LC parallel resonance circuit wherein a floating capacitance formed between the spirally wound conductor patterns is used as a capacitance component. The power feeding circuit board 50 is a single-layer board made of a dielectric material or a magnetic material.

According to the thirteenth embodiment, in the wireless IC device 1 m, the power feeding circuit 56 is mainly magnetically coupled with the radiating plate 20. Accordingly, like the above-described embodiments, the wireless IC device 1m receives a high-frequency signal (e.g. , a signal in a UHF band) radiated from a reader/ writer (not shown) atthe radiating plate 20. By resonating the power feeding circuit 56, the wireless IC device 1 m supplies the wireless IC chip 5 with only a reception signal in a predetermined frequency band. Meanwhile, the wireless IC device 1 m extracts predetermined energy from the reception signal, and by using this energy as a driving source, the wireless IC device 1 m matches the information stored in the wireless IC chip 5 with a predetermined frequency at the powerfeeding circuit 56. Thereafter, the wireless IC device 1 m propagates a transmission signal from the inductance element of the power feeding circuit 56 to the radiating plate 20 via magnetic coupling. The radiating plate 20 transmits the transmission signal to the reader/writer.

Like the first embodiment, the wireless IC chip 5 is mounted on the rigid power feeding circuit board 50 having a small area. Accordingly, the wireless IC chip 5 can be precisely positioned and can be connected to the power feeding circuit board 50 using a solder bump.

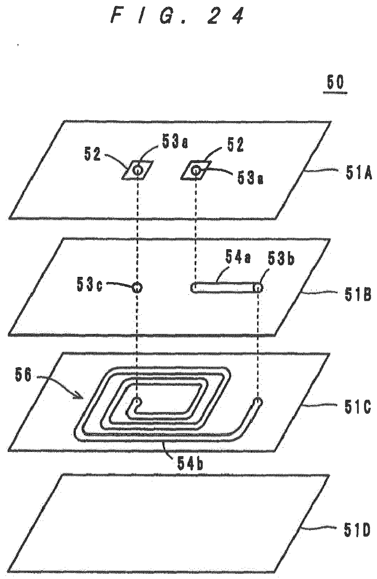

### Fourteenth Embodiment (refer to Figs. 23 and 24)

According to a fourteenth embodiment, as shown in Fig. 23, in a wireless IC device 1 n, a power feeding circuit 56 includes a coil-shaped electrode pattern incorporated in a power feeding circuit board 50. As shown in Fig. 24, ceramic sheets 51 A to 51 D made of a dielectric material are laminated, pressed, and sintered so as to form the power feeding circuit board 50. The ceramic sheet 51A includes connection electrodes 52 and via-hole conductors 53a formed therein. The ceramic sheet 51B includes a conductor pattern 54a and via-hole conductors 53b and 53c formed therein. The ceramic sheet 51C includes a conductor pattern 54b formed therein. Each of a plurality of the ceramic sheets 51 D has no components therein.

By laminating the sheets 51A to 51 D, the power feeding circuit board 50 incorporating the power feeding circuit 56 can be obtained. The power feeding circuit 56 includes a resonance circuit composed of a spirally wound inductance element and a capacitance element defined by a floating capacitance between lines of the spirally wound electrode pattern. The connection electrodes 52 disposed at either end of the power feeding circuit 56 are connected to the wireless IC chip 5 via solder bumps 6. The operation and advantages of the fourteenth embodiment are the same as those of the thirteenth embodiment.

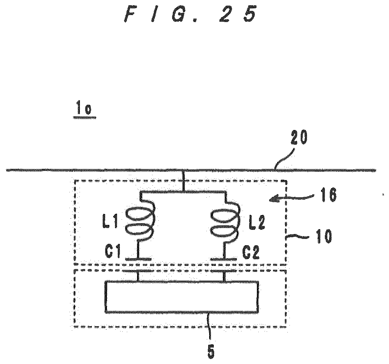

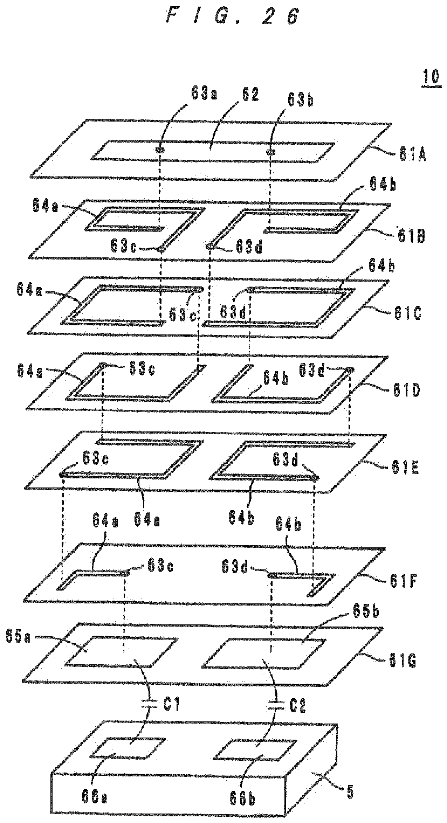

### Fifteenth Embodiment (refer to Figs. 25 and 26)

According to a fifteenth embodiment, as shown by an equivalent circuit in Fig. 25, a wireless IC device 1₀ includes a wireless IC chip 5 and a power feeding circuit board 10 that are capacitively coupled with each other, and the power feeding circuit board 10 is DC-connected to a radiating plate 20. The power feeding circuit board 10 incorporates a power feeding circuit 16 including two LC series resonance circuits. The winding axes of inductance elements L1 and L2 are perpendicular to the radiating plate 20. One end ofthe inductance element L1 and one end of the inductance element L2 are connected to capacitor electrodes 65a and 65b that form capacitance elements C1 and C2 (refer to Fig. 26), respectively. The other end of the inductance element L1 and the other end of the inductance element L2 are directly connected to each other by a connection electrode 62 disposed on the upper surface (in Figs. 25 and 26) of the board 10. In addition, capacitor electrodes 66a and 66b that form the capacitance elements C1 and C2 (refer to Fig. 26), respectively, are disposed on the upper surface (in Figs. 25 and 26) of the wireless IC chip 5.

More specifically, as shown in Fig. 26, ceramic sheets 61 A to 61 G made of a dielectric material are laminated, pressed, and sintered so as to form the power feeding circuit board 10. The sheet 61 A includes the connection electrode 62 and via-hole conductors 63a and 63b formed therein. Each of the sheets 61B to 61F includes conductor patterns 64a and 64b and via-hole conductors 63c and 63d formed therein. The sheet 61 G includes capacitor electrodes 65a and 65b formed therein.

By laminating the sheets 61 Ato 61 G, the power feeding circuit 16 including two LC series resonance circuits can be obtained. In the two LC series resonance circuits, the capacitance elements C1 and C2 are connected in series to the inductance elements L1 and L2, respectively.

That is, the capacitance element C1 is formed between the two parallel flat electrode patterns, that is, between the electrode 66a serving as a chip-side electrode pattern and the electrode 65a serving as a board-side electrode pattern. The capacitance element C2 is formed between the two parallel flat electrode patterns, that is, between the electrode 66b serving as a chip-side electrode pattern and the electrode 65b serving as a board-side electrode pattern. The wireless IC chip 5 is bonded and connected to the powerfeeding circuit board 10 via an insulating adhesive layer. The power feeding circuit board 10 is also DC-connected to the radiating plate 20 via a connection electrode 62 which is a second board-side electrode pattern. The connection electrode 62 and the radiating plate 20 may be connected to each other via a solder, a conductive adhesive agent or the like.

The operation and advantages of the fifteenth embodiment are the same as those of the first embodiment. That is, the wireless IC device 1 o receives a high-frequency signal (e.g., a signal in a UHF band) radiated from a reader/writer (not shown) at the radiating plate 20. By resonating the powerfeeding circuit 16 (the LC series resonance circuit composed of the inductance element L1 and the capacitance element C1 and the LC series resonance circuit composed of the inductance element L2 and the capacitance element C2) that is DC-connected to the radiating plate 20, the wireless IC device 1₀ supplies the wireless IC chip 5 with only a reception signal in a predetermined frequency band. Meanwhile, the wireless IC device 1o extracts predetermined energy from the reception signal, and by using this energy as a driving source, the wireless IC device 1o matches the information stored in the wireless IC chip 5 with a predetermined frequency at the powerfeeding circuit 16. Thereafter, the wireless IC device 1o propagates a transmission signal to the radiating plate 20 that is DC-connected to the power feeding circuit 16. The radiating plate 20 transmits the transmission signal to the reader/writer. The powerfeeding circuit 16 is capacitively coupled with the wireless IC chip 5 by the capacitance elements C1 and C2, so that electric power and transmission/reception signals are exchanged therebetween.

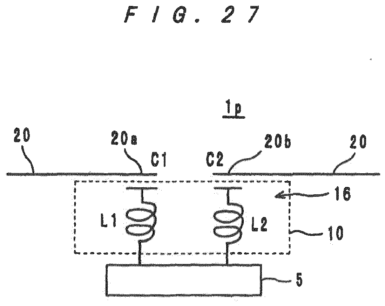

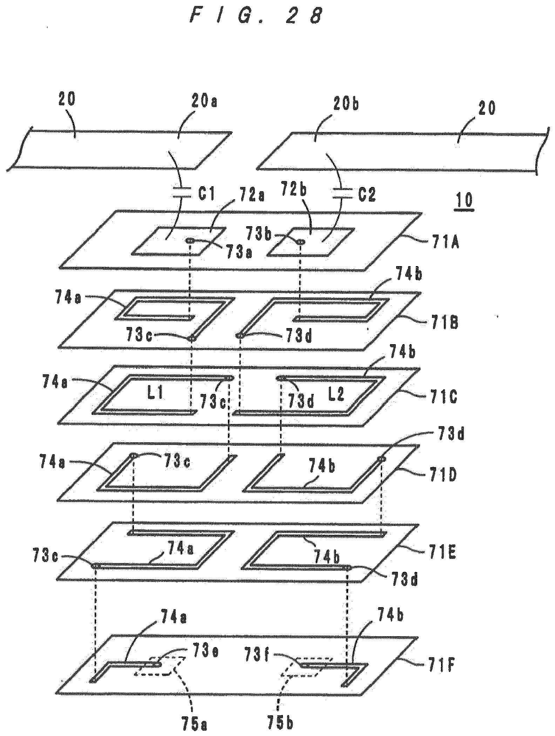

The areas of the capacitor electrodes 65a and 65b formed on the power feeding circuit board 10 are larger than the areas of the capacitor electrodes 66a and 66b formed on the wireless IC chip 5, respectively. Accordingly, even when the accuracy in positioning of the wireless IC chip 5 on the power feeding circuit board 10 somewhat varies, variations in capacitance formed between the capacitor electrodes 65a and 66a and between the capacitor electrodes 65b and 66b are reduced. In addition, the capacitance elements C1 and C2 are disposed downstream of the wireless IC chip 5, which improves the resistance to surge. Sixteenth Embodiment (refer to Figs. 27 and 28)

According to a sixteenth embodiment, as shown by an equivalent circuit in Fig. 27, in a wireless IC device 1 p, a powerfeeding circuit board 10 Is capacitively coupled with radiating plates 20. The power feeding circuit board 10 incorporates a power feeding circuit 16 including two LC series resonance circuits. One end of an inductance element L1 and one end of an inductance element L2 are connected to the wireless IC chip 5. The other end of the inductance element L1 and the other end of the inductance element L2 are connected to capacitor electrodes 72a and 72b that are disposed on the upper surface (in Figs. 27 and 28) of the board 10 and that form capacitance elements C1 and C2 (refer to Fig. 28), respectively. An end portion 20a of one of the radiating plates 20 serves as the other capacitor electrode for the capacitance element C1, while an end portion 20b of the other radiating plate 20 serves as the other capacitor electrode for the capacitance element C2.

More specifically, as shown in Fig. 28, ceramic sheets 71 A to 71F made of a dielectric material are laminated, pressed, and sintered so as to form the power feeding circuit board 10. The sheet 71 A includes the capacitor electrodes 72a and 72b and via-hole conductors 73a and 73b formed therein. Each of the sheets 71 B to 71 E includes conductor patterns 74a and 74b and via-hole conductors 73c and 73d formed therein. The sheet 71 F includes the conductor patterns 74a and 74b formed on one surface and connection electrodes 75a and 75b formed on the other surface thereof. The conductor patterns 74a and 74b of the sheet 71F are connected to the connection electrodes 75a and 75b through via-hole conductors 73e and 73f, respectively.

By laminating the sheets 71A to 71 F, the power feeding circuit 16 including two LC series resonance circuits can be obtained. In the two LC series resonance circuits, the capacitance elements C1 and C2 are connected in series to the inductance elements L1 and L2, respectively. By bonding the power feeding circuit board 10 to the radiating plates 20 by an adhesive agent, the capacitor electrodes 72a and 72b which are flat electrode patterns parallel to the radiating plates 20 face the end portions 20a and 20b of the radiating plates 20, respectively, with the insulating adhesive agent in-between, and thus, the capacitance elements C1 and C2 are defined. In addition, by connecting the connection electrodes 75a and 75b to the wireless IC chip 5 via solder bumps, one end of the inductance element L1 and one end of the inductance element L2 are connected to the wireless IC chip 5, and therefore, the power feeding circuit board 10 is DC-connected to the wireless IC chip 5.

If the adhesive agent includes, for example, particles of a dielectric material, the adhesive agent layer has a dielectric property, and the capacitance of the capacitance elements C1 and C2 is increased. In addition, while the sixteenth embodiment has been described with reference to the case where the capacitor electrodes 72a and 72b serving as a second board-side electrode patterns are disposed on the upper surface (in Figs. 27 and 28) of the power feeding circuit board 10, the capacitor electrodes 72a and 72b may be formed Inside the power feeding circuit board 10 (but at a location adjacent to the radiating plates 20). Alternatively, the capacitor electrodes 72a and 72b may be formed in an inner layer of the board 10.

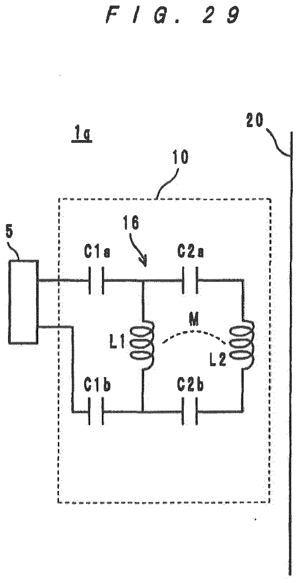

The operation and advantages of the sixteenth embodiment are basically the same as those of the first embodiment. That Is, the wireless IC device 1p receives a high-frequency signal (e.g., a signal in a UHF band) radiated from a reader/writer (not shown) at the radiating plate 20. By resonating the power feeding circuit 16 (the LC series resonance circuit composed of the inductance element L1 and the capacitance element C1 and the LC series resonance circuit composed of the inductance element L2 and the capacitance element C2) that is capacitively coupled with the radiating plates 20, the wireless IC device 1p supplies the wireless IC chip 5 with only a reception signal in a predetermined frequency band. Meanwhile, the wireless IC device 1 p extracts predetermined energy from the reception signal, and by using this energy as a driving source, the wireless IC device 1 p matches the information stored in the wireless IC chip 5 with a predetermined frequency at the power feeding circuit 16. Thereafter, the wireless IC device 1p propagates a transmission signal to the radiating plate 20 via the capacitive coupling provided by the capacitance elements C1 and C2. The radiating plate 20 transmits the transmission signal to the reader/writer. Seventeenth Embodiment (refer to Figs. 29 to 31)

According to a seventeenth embodiment, as shown by an equivalent circuit in Fig. 29, a wireless IC device 1q includes a power feeding circuit 16 including inductance elements L1 and L2 that are magnetically coupled with each other. The inductance element L1 is connected to a wireless IC chip 5 via capacitance elements C1 a and C1 b. In addition, the inductance element L1 is connected to the inductance element L2 in parallel via capacitance elements C2a and C2b. That is, the power feeding circuit 16 includes an LC series resonance circuit composed of the inductance element L1 and the capacitance elements C1a and C1 b. The power feeding circuit 16 further includes an LC series resonance circuit composed of the inductance element L2 and the capacitance elements C2a and C2b. The two resonance circuits are coupled with each other via magnetic coupling indicated by "M" shown in Fig. 29. In addition, the two inductance elements L1 and L2 are magnetically coupled with the radiating plate 20.

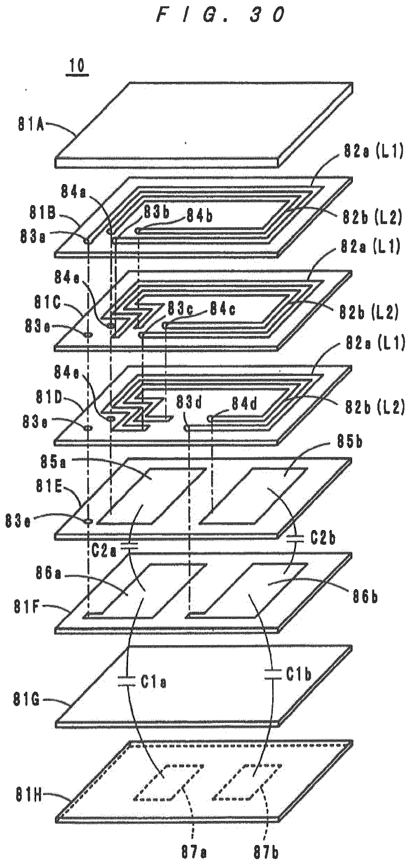

More specifically, as shown in Fig. 30, ceramic sheets 81A to 81 H made of a dielectric material are laminated, pressed, and sintered so as to form the power feeding circuit board 10. The sheet 81A has no components formed therein. The sheet 81 B includes conductor patterns 82a and 82b and via-hole conductors 83a, 83b, 84a, and 84b formed therein. The sheet 81C includes conductor patterns 82a and 82b and via-hole conductors 83c, 84c, 83e, and 34e formed therein. The sheet 81 D includes the conductor patterns 82a and 82b and via-hole conductors 83d, 84d, 83e, and 34e formed therein. The sheet 81E includes capacitor electrodes 85a and 85b and a via-hole conductor 83e formed therein. The sheet 81F includes capacitor electrodes 86a and 86b formed therein. The sheet 81G has no components formed therein. The sheet 81 H includes capacitor electrodes 87a and 87b formed on the bottom surface (in Fig. 30) thereof.

By laminating the sheets 81A to 81 H, the conductor patterns 82a are connected to each other via the-via-hole conductors 83b and 83c so as to form the inductance element L1. Also, the conductor patterns 82b are connected to each other via the via-hole conductors 84b and 84c so as to form the inductance element L2. The capacitor electrodes 86a and 87a form the capacitance element C1 a. The capacitor electrode 86a is connected to one end of the inductance element L1 via the via-hole conductor 83e. The capacitor electrodes 86b and 87b form the capacitance element C1 b. The capacitor electrode 86b is connected to the other end of the inductance element L1 via the via-hole conductor 83d. Also, the capacitor electrodes 85a and 86a form the capacitance element C2a. The capacitor electrode 85a is connected to one end of the inductance element L2 via the via-hole conductor 84e. The capacitor electrodes 85b and 86b form the capacitance element C2b. The capacitor electrode 85b is connected to the other end of the inductance element L2 via the via-hole conductor 84d.

The operation and advantages of the seventeenth embodiment are basically similar to those of the first embodiment. That is, the wireless IC device 1q receives a high-frequency signal (e.g., a signal in a UHF band) radiated from a reader/writer (not shown) at the radiating plate 20. By resonating the powerfeeding circuit 16 (the LC series resonance circuit composed of the inductance element L1 and the capacitance elements C1 a and C1 b, and the LC series resonance circuit composed of the inductance element L2 and the capacitance elements C2a and C2b) that is mainly magnetically coupled with the radiating plate 20, the wireless IC device 1 q supplies the wireless IC chip 5 with only a reception signal in a predetermined frequency band. Meanwhile, the wireless IC device 1 q extracts predetermined energy from the reception signal, and by using this energy as a driving source, the wireless IC device 1q matches the information stored in the wireless IC chip 5 with a predetermined frequency at the power feeding circuit 16. Thereafter, the wireless IC device 1q propagates a transmission signal from the inductance elements L1 and L2 of the power feeding circuit 16 to the radiating plate 20 via magnetic coupling. The radiating plate 20 transmits the transmission signal to the reader/writer.

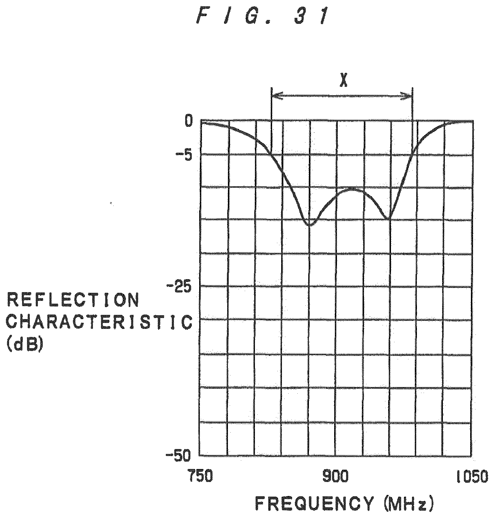

In particular, according to the seventeenth embodiment, as shown in Fig. 31, the bandwidth X wherein a reflection characteristic of -5 dB or less can be obtained is an extremely broad frequency band not less than about 150 MHz. This is because the power feeding circuit 16 includes a plurality of LC resonance circuits having the inductance elements L1 and L2 that are magnetically coupled with each other with high degree of coupling. In addition, the capacitance elements C1 a and C1 b are disposed downstream of the wireless IC chip 5, which improves the resistance to surge.

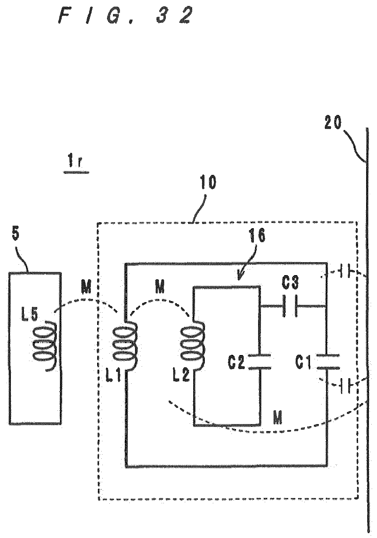

### Eighteenth Embodiment (refer to Figs. 32 to 34)

According to an eighteenth embodiment, as shown by an equivalent circuit in Fig. 32, a wireless IC device 1 r includes a power feeding circuit 16 having Inductance elements L1 and L2 that are magnetically coupled with each other with high degree of coupling. The inductance element L1 is magnetically coupled with an inductance element L5 provided In the wireless IC chip 5. The inductance element L2 and a capacitance element C2 form an LC series resonance circuit. The capacitance element C1 is capacitively coupled with the radiating plate 20. A capacitance element C3 is inserted between the capacitance elements C1 and C2.

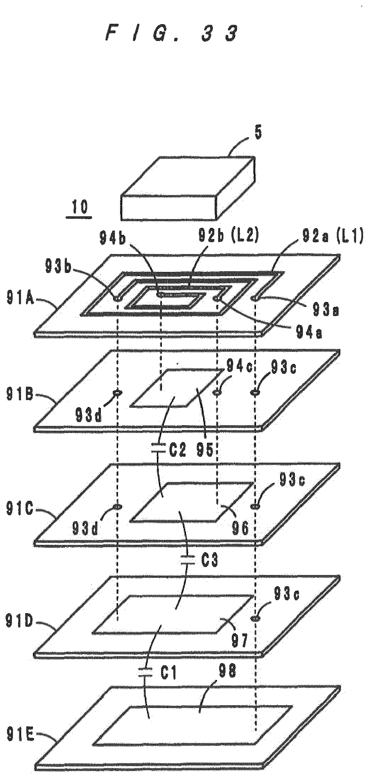

More specifically, as shown in Fig. 33, ceramic sheets 91A to 91E made of a dielectric material are laminated, pressed, and sintered so as to form the power feeding circuit board 10. The sheet 91 A includes conductor patterns 92a and 92b and via-hole conductors 93a, 93b, 94a, and 94b formed therein. The sheet 91B includes a capacitor electrode 95 and via-hole conductors 93c, 93d, and 94c formed therein. The sheet 91C includes a capacitor electrode 96 and the via-hole conductors 93c and 93d formed therein. The sheet 91 D includes a capacitor electrode 97 and the via-hole conductor 93c formed therein. The sheet 91 E includes a capacitor electrode 98.

When the sheets 91A to 91E are laminated, the conductor pattern 92a forms the inductance element L1. The conductor pattern 92b forms the inductance element L2. The capacitor electrodes 97 and 98 form the capacitance element C1. One end of the inductance element L1 is connected to the capacitor electrode 98 via the via-hole conductors 93a and 93c. The other end of the inductance element L1 is connected to the capacitor electrode 97 via the via-hole conductors 93b and 93d. The capacitor electrodes 95 and 96 form the capacitance element C2. One end of the inductance element L2 is connected to the capacitor electrode 96 via the via-hole conductors 94a and 94c. The other end of the inductance element L2 is connected to the capacitor electrode 95 via the via-hole conductor 94b. In addition, the capacitor electrodes 96 and 97 form the capacitance element C3.

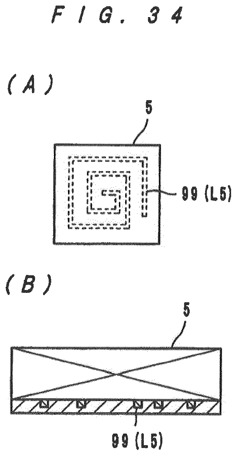

Furthermore, as shown in Fig. 34, a coll-shaped electrode pattern 99 is disposed on a surface of the wireless IC chip 5 as a chip-side electrode pattern, and the coil-shaped electrode pattern 99 defines the inductance element L5. A protecting film, for example, a resin film is provided on the surface of the coil-shaped electrode pattern 99. In this way, the inductance elements L1 defined by the coil-shaped electrode pattern serving as a board-side electrode pattern is magnetically coupled with the coil-shaped electrode pattern 99.

The operation and advantages of the eighteenth embodiment are basically similar to those of the first embodiment. That is, the wireless IC device 1r receives a high-frequency signal (e.g., a signal in a UHF band) radiated from a reader/writer (not shown) at the radiating plate 20. By resonating the powerfeeding circuit 16 (the LC series resonance circuit composed of the Inductance element L2 and the capacitance element C2) that is capacitively and magnetically coupled with the radiating plate 20, the wireless IC device 1 r supplies the wireless IC chip 5 with only a reception signal in a predetermined frequency band. Meanwhile, the wireless IC device 1 r extracts predetermined energy from the reception signal, and by using this energy as a driving source, the wireless IC device 1 r matches the information stored in the wireless IC chip 5 with a predetermined frequency at the power feeding circuit 16. Thereafter, the wireless IC device 1 r propagates a transmission signal from the inductance elements L1 and L2 of the power feeding circuit 16 to the radiating plate 20 via magnetic coupling. The radiating plate 20 transmits the transmission signal to the reader/writer. The powerfeeding circuit 16 is magnetically coupled with the wireless IC chip 5 by the inductance elements L1 and L5. Thus, electrical power and transmission/reception signals are exchanged.

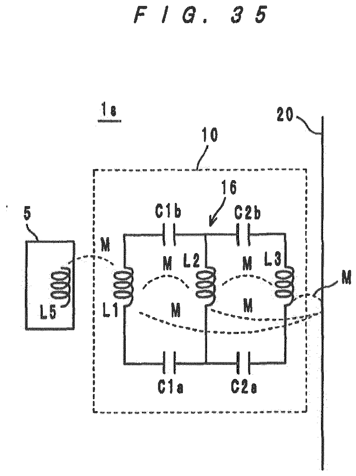

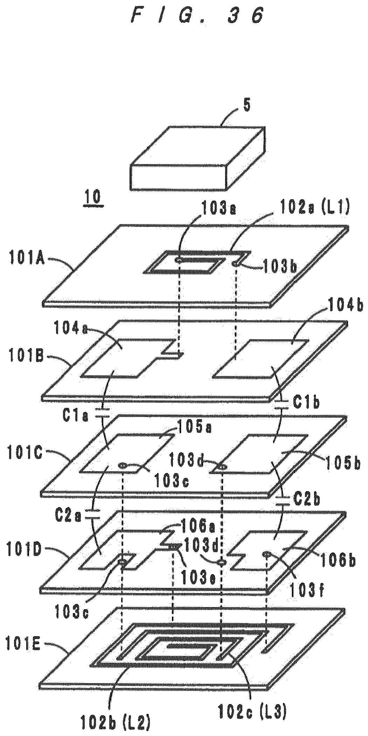

### Nineteenth Embodiment (refer to Figs. 35 and 36)

According to a nineteenth embodiment, as shown by an equivalent circuit in Fig. 35, a wireless IC device 1s includes a power feeding circuit 16 having inductance elements L1, L2, and L3 that are magnetically coupled with each other with high degree of coupling. The inductance element L1 is magnetically coupled with an inductance element L5 provided in the wireless IC chip 5. The inductance element L2 and capacitance elements C1a and C1b form an LC series resonance circuit. The inductance element L3 and capacitance elements C2a and C2b form an LC series resonance circuit. The inductance elements L1, L2, and L3 are magnetically coupled with the radiating plate 20.

More specifically, as shown in Fig. 36, ceramic sheets 101 A to 101E made of a dielectric material are laminated, pressed, and sintered so as to form the power feeding circuit board 10. The sheet 101 A includes conductor pattern 102a and via-hole conductors 103a and 103b formed therein. The sheet 101 B includes capacitor electrodes 104a and 104b formed therein. The sheet 101C Includes capacitor electrodes 105a and 105b and via-hole conductors 103c and 103d formed therein. The sheet 101D includes capacitor electrodes 106a and 106b, the via -ole conductors 103c and 103d, and via-hole conductors 103e and 103fformed therein. The sheet 101E includes conductor patterns 102b and 102c formed therein.Thatis, aspace is formed between the electrodes 104a, 105a and 106a and the electrodes 104b, 105b and 106b, which define the capacitance elements, so that the magnetic fluxes emanated from the inductance element L1 reach the inductance elements L2, L3, and the radiating plate 20.

When the sheets 101A to 101E are laminated, the conductorpattern 102a forms the inductance element L1. The conductor pattern 102b forms the inductance element L2. The conductor pattern 102c forms the inductance element L3. The capacitor electrodes 104a and 105a form the capacitance element C1 a. The capacitor electrodes 104b and 105b form the capacitance element C1b. The capacitor electrodes 105a and 106a form the capacitance element C2a. The capacitor electrodes 105b and 106b form the capacitance element C2b.

One end of the inductance element L1 is connected to the capacitor electrode 104a via the via-hole conductor 103a. The other end of the inductance element L1 is connected to the capacitor electrode 104b via the via-hole conductor 103b. One end of the inductance element L2 is connected to the capacitor electrode 105a via the via-hole conductor 103c. The other end of the inductance element L2 is connected to the capacitor electrode 106b via the via-hole conductor 103f. One end of the inductance element L3 is connected to the capacitor electrode 106a via the via-hole conductor 103e. The other end of the inductance element L3 is connected to the capacitor electrode 105b via the via-hole conductor 103d.

Furthermore, a coil-shaped electrode pattern 99 as shown in Fig. 34 is disposed on a surface of the wireless IC chip 5 as a chip-side electrode pattern, and the coil-shaped electrode pattern 99 defines the inductance element L5. A protecting film, for example, a resin film is provided on the surface of the coil-shaped electrode pattern 99. In this way, the inductance element L1 defined by the coil-shaped electrode pattern serving as a board-side electrode pattern is magnetically coupled with the coil-shaped electrode pattern 99.

The operation and advantages of the nineteenth embodiment are basically similar to those of the seventeenth embodiment. That is, the wireless IC device 1s receives a high-frequency signal (e.g., a signal in a UHF band) radiated from a reader/writer (not shown) using the radiating plate 20. By resonating the power feeding circuit 16 (the LC series resonance circuit composed of the inductance element L2 and the capacitance elements C1 a and C1 b, and the LC series resonance circuit it composed of the inductance element L3 and the capacitance elements C2a and C2b) that is magnetically coupled with the radiating plate 20, the wireless 1C device 1s supplies the wireless IC chip 5 with only a reception signal In a predetermined frequency band. Meanwhile, the wireless IC device 1s extracts predetermined energy from the reception signal, and by using this energy as a driving source, the wireless IC device 1s matches the information stored in the wireless IC chip 5 with a predetermined frequency at the powerfeeding circuit 16. Thereafter, the wireless IC device 1 s propagates a transmission signal from the inductance elements L1, L2, and L3 of the power feeding circuit 16 to the radiating plate 20 via magnetic coupling. The radiating plate 20 transmits the transmission signal to the reader/writer. The powerfeeding circuit 16 is magnetically coupled with the wireless IC chip 5 by the inductance elements L1 and L5, and thus, electrical powerandtransmission/reception signals are exchanged.

In particular, according to the nineteenth embodiment, the powerfeed ing circuit 16 includes a plurality of LC resonance circuits having the inductance elements L2 and L3 that are magnetically coupled with each other. Therefore, like the seventeenth embodiment, the frequency band Is increased.

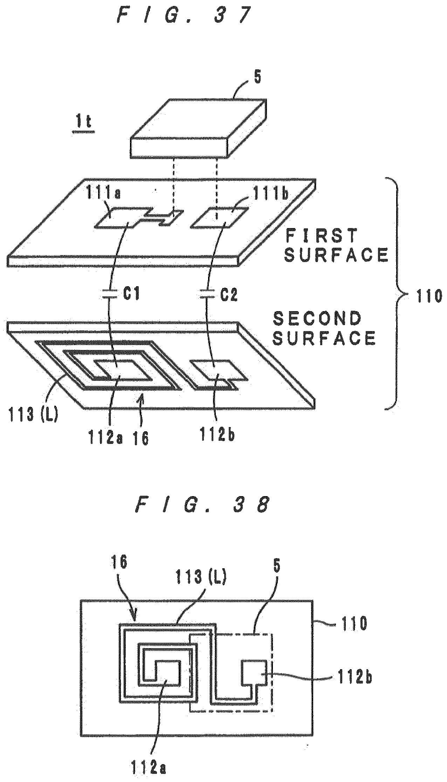

### Twentieth Embodiment (refer to Figs. 37 to 42)

According to a twentieth embodiment, a wireless IC device 1t includes a power feeding circuit board 110 of a single-layer type. The equivalent circuit of the wireless IC device 1t is similar to that shown in Fig. 3. That is, the powerfeeding circuit 16 includes an LC series resonance circuit in which capacitance elements C1 and C2 are connected to either end of an inductance element L. The powerfeeding circuit board 110 is a ceramic board made of a dielectric material. As shown in Fig. 37, capacitor electrodes 111a and 111 b are formed on the first surface of the powerfeeding circuit board 110. Capacitor electrodes 112a and 112b and a conductor pattern 113 are formed on the second surface of the power feeding circuit board 110. The capacitor electrodes 111a and 112a form the capacitance element C1. The capacitor electrodes 111 b and 112b form the capacitance element C2.

The operation and advantages of the twentieth embodiment are basically similar to those of the seventeenth embodiment. That is, the wireless IC device It receives a high-frequency signal (e.g., a signal in a UHF band) radiated from a reader/writer (not shown) at the radiating plate 20. By resonating the powerfeeding circuit 16 (the LC series resonance circuit composed of the inductance element L and the capacitance elements C1 and C2) that is magnetically coupled with the radiating plate 20, the wireless IC device 1t supplies the wireless IC chip 5 with only a reception signal in a predetermined frequency band. Meanwhile, the wireless IC device It extracts predetermined energy from the reception signal, and by using this energy as a driving source, the wireless IC device 1t matches the information stored in the wireless IC chip 5 with a predeterminedfrequency atthe power feeding circuit 16. Thereafter, the wireless IC device 1t propagates a transmission signal from the inductance element L of the power feeding circuit 16 to the radiating plate 20 via magnetic coupling. The radiating plate 20 transmits the transmission signal to the reader/writer.

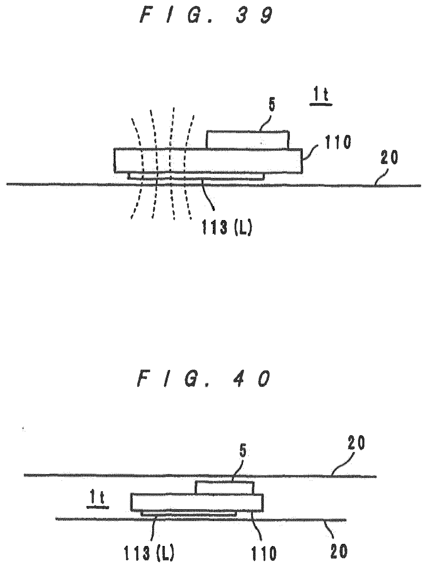

In particular, according to the twentieth embodiment, as shown in Figs. 38 and 39, the inductance element L overlaps the wireless IC chip 5 only partially in a plan view. Accordingly, most magnetic fluxes generated by the inductance element L are not blocked by the wireless IC chip 5. Thus, the magnetic fluxes rise markedly.

In addition, according to the twentieth embodiment, as shown in Fig. 40, the powerfeeding circuit board 110 having the wireless IC chip 5 mounted thereon may be sandwiched by radiating plates 20. In this way, the magnetic coupling efficiency between the powerfeeding circuit 16 and the radiating plates 20 is improved, and gain is also improved.

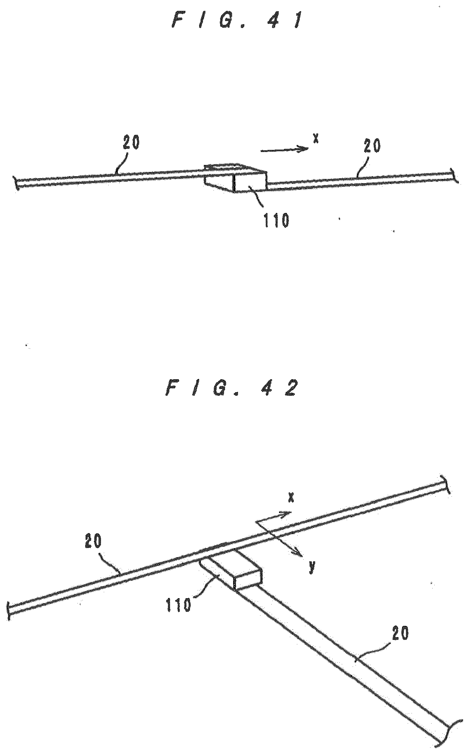

As examples of disposing the two radiating plates 20 on the upper surface and on the lower surface of the power feeding circuit board 110, respectively, the radiating plates 20 may be disposed in a line in the x-axis direction as shown in Fig. 41, and alternatively, may be disposed in the x-axis direction and in the y-axis direction, respectively, as shown in Fig. 42.

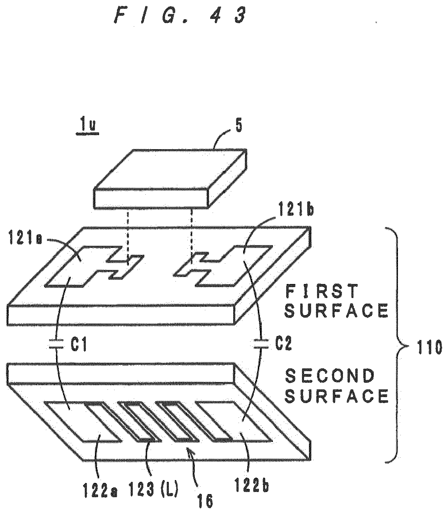

### Twenty-First Embodiment (refer to Fig. 43)

According to a twenty-first embodiment, a wireless IC device 1u includes an inductance element L formed from a meandering-shaped electrode pattern. The equivalent circuit of the wireless IC device 1 u is similar to that shown in Fig. 3. That is, the power feeding circuit 16 includes an LCseries resonance circuit in which capacitance elements C1 and C2 are connected to either end of an inductance element L. A power feeding circuit board 110 is a ceramic single-layer board made of a dielectric material. As shown in Fig. 43, capacitor electrodes 121a and 121 b are formed on the first surface of the powerfeeding circuit board 110. Capacitor electrodes 122a and 122b and a meandering conductor pattern 123 are formed on the second surface of the power feeding circuit board 110. The capacitor electrodes 121 a and 122a form the capacitance element C1. The capacitor electrodes 121 b and 122b form the capacitance element C2.

The operation and advantages of the twenty-first embodiment are basically similar to those of the first embodiment. That is, the wireless IC device 1 u receives a high-frequency signal (e.g., a signal in a UHF band) radiated from a reader/writer (not shown) at the radiating plate 20. By resonating the powerfeeding circuit 16 (the LC series resonance circuit composed of the inductance element L and the capacitance elements C1 and C2) that is magnetically coupled with the radiating plate 20, the wireless IC device 1 u supplies the wireless IC chip 5 with only a reception signal in a predetermined frequency band. Meanwhile, the wireless IC device 1 u extracts predetermined energy from the reception signal, and by using this energy as a driving source, the wireless IC device 1 u matches the information stored in the wireless IC chip 5 with a predetermined frequency at the power feeding circuit 16. Thereafter, the wireless IC device 1u propagates a transmission signal from the inductance element L of the power feeding circuit 16 to the radiating plate 20 via magnetic coupling. The radiating plate 20 transmits the transmission signal to the reader/writer.

In particular, according to the twenty-first embodiment, as shown in Figs. 38 and 39, since the inductance element L is composed of the meandering conductor pattern 123, the wireless IC device 1 u can effectively transmit and receive a high-frequency signal.

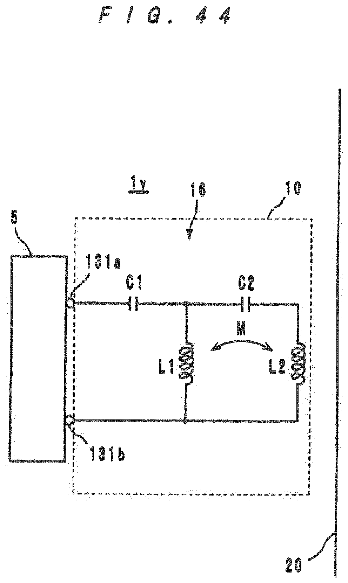

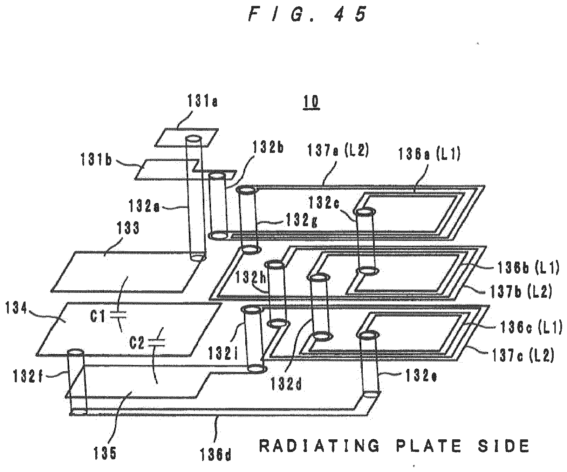

In the twentieth and twenty-first embodiments, the power feeding circuit board 110 may be a multilayer board. Twenty-Second Embodiment (refer to Figs. 44 and 45)

According to a twenty-second embodiment, as shown by an equivalent circuit in Fig. 44, a wireless IC device 1v includes a power feeding circuit 16 having inductance elements L1 and L2 that are magnetically coupled with each other (indicated by a reference symbol "M"). One end of the inductance element L1 is connected to a wireless IC chip 5 via a capacitance element C1 and a connection electrode 131a, and is further connected to one end of the inductance element L2 via a capacitance element C2. The other end of the inductance element L1 and the other end of the inductance element L2 are connected to the wireless IC chip 5 via a connection electrode 131b. That is, the power feeding circuit 16 includes an LC series resonance circuit composed of the inductance element L1 and the capacitance element C1, and an LC series resonance circuit composed of the inductance element L2 and the capacitance element C2. The inductance elements L1 and L2 are magnetically coupled with the radiating plate 20.

The powerfeeding circuit board 10 is configured as shown in Fig. 45. The connection electrode 131a is connected to a capacitor electrode 133 via a via-hole conductor 132a. The capacitor electrode 133 faces a capacitor electrode 134 so as to form the capacitance element C1. In addition, the capacitor electrode 134 faces a capacitor electrode 135 so as to form the capacitance element C2. The connection electrode 131 b is connected to two-forked conductor patterns 136a and 137a via a via-hole conductor 132b. The conductor pattern 136a is connected to a conductor pattern 136b via a via-hole conductor 132c. The conductor pattern 136b is connected to a conductor pattern 136c via a via-hole conductor 132d. The conductor pattern 136c is connected to a conductor pattern 136d via a via-hole conductor 132e. Finally, the conductor pattern 136d is connected to the capacitor electrode 134 via a via-hole conductor 132f.

In contrast, the conductor pattern 137a is connected to a conductor pattern 137b via a via-hole conductor 132g. The conductor pattern 137b is connected to a conductor pattern 137c via a via-hole conductor 132h. The conductor pattern 137c is connected to the capacitor electrode 135 via a via-hole conductor 132l. The conductor patterns 136a, 136b, and 136c form the inductance element L1. The conductor patterns 137a, 137b, and 137c form the inductance element L2. Note that, in Fig. 45, the ceramic sheets made of a dielectric material are not shown.

The operation and advantages of the twenty-second embodiment are the same as those of the first embodiment. That is, the wireless IC device 1v receives a high-frequency signal (e.g., a signal in a UHF band) radiated from a reader/writer (not shown) at a radiating plate 20. By resonating the power feeding circuit 16 (the LC series resonance circuit composed of the inductance element L1 and the capacitance element C1, and the LC series resonance circuit composed of the inductance element L2 and the capacitance element C2) that is magnetically coupled with the radiating plate 20, the wireless IC device 1v supplies the wireless IC chip 5 with only a reception signal in a predetermined frequency band. Meanwhile, the wireless IC device 1v extracts predetermined energy from the reception signal, and by using this energy as a driving source, the wireless IC device 1v matches the information stored in the wireless IC chip 5 with a predetermined frequency at the power feeding circuit 16. Thereafter, the wireless IC device 1v propagates a transmission signal to the radiating plate 20 from the inductance elements L1 and L2 of the powerfeeding circuit 16 to the radiating plate 20 via magnetic coupling. The radiating plate 20 transmits the transmission signal to the reader/writer.

In particular, according to the twenty-second embodiment, the capacitor electrode 133,134, and 135, the inductor conductor patterns 136a to 136c, and the inductor conductor patterns 137a to 137c are disposed so as to be parallel to the radiating plate 20. Accordingly, magnetic fields generated by the inductor conductor patterns 136a to 136c and 137a to 137c are not blocked by the capacitor electrodes 133, 134, and 135. Thus, the radiation properties of the inductor conductor patterns 136a to 136c and 137a to 137c are improved.

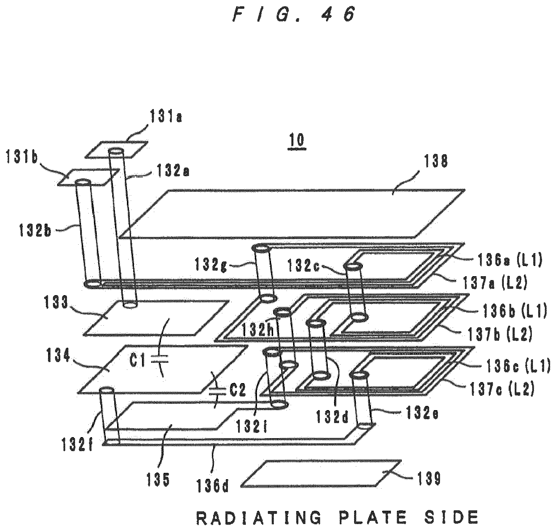

### Twenty-Third Embodiment (refer to Fig. 46)

According to atwenty-third embodiment, a power feeding circuit board 10 including a power feeding circuit 16 incorporating an equivalent circuit as shown in Fig. 44 is employed. As shown in Fig. 46, this power feeding circuit board 10 has a structure similar to that of the powerfeeding circuit board 10 shown in Fig.45. However, in addition to the structure shown by Fig. 45, a reflector (a reflecting pattern) 138 and a wave director (a wave director pattern) 139 are provided in a section where magnetic fields are generated by the inductorconductor patterns 136a to 136c and the inductor conductor patterns 137a to 137c. By using the reflector 138 and the wave director 139, the radiation characteristic and the directional characteristic from the power feeding circuit 16 to the radiating plate 20 can be easily controlled. Thus, an external electromagnetic effect can be minimized, thereby stabilizing the resonance characteristics. The operation and advantages of the twenty-third embodiment are basically similar to those of the twenty-second embodiment.

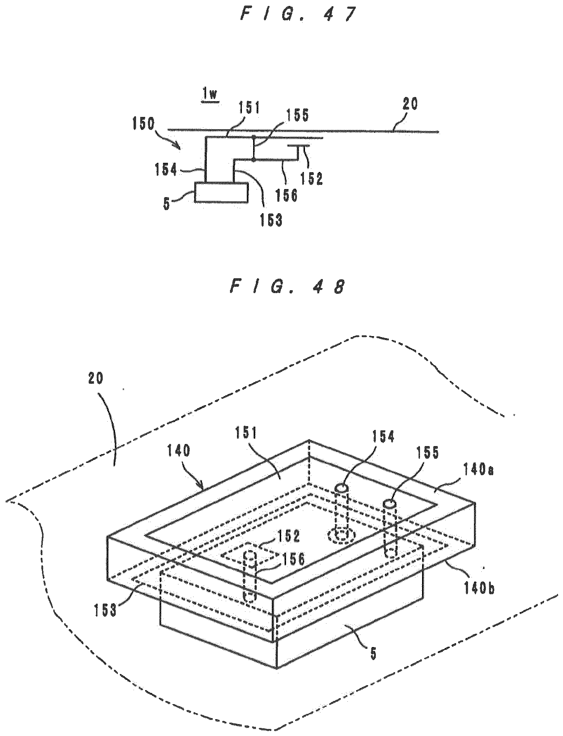

### Twenty-fourth Embodiment (refer to Figs. 47 and 48)

According to a twenty-fourth embodiment, a wireless IC device 1w includes a power feeding circuit 150 formed as a distributed-constant-type resonance circuit of an inverted F antenna configuration. Fig. 47 illustrates an equivalent circuit of the wireless IC device 1w. More specifically, as shown in Fig. 48, a power feeding circuit board 140 is a multilayer board made of ceramic sheets. The power feeding circuit board 140 includes a high-side electrode 151 disposed on a first surface 140a thereof, a capacitor electrode 152 inside, and a low-side electrode 153 disposed on a second surface 140b thereof. The high-side electrode 151 is electrically connected to a radiating plate 20 via magnetic coupling and capacitive coupling. The high-side electrode 151 is further connected to a high-side terminal of a wireless IC chip 5 via a power feeding pln 154. The low-side electrode 153 is connected to a low-side terminal of the wireless IC chip 5. The low-side electrode 153 is further connected to the high-side electrode 151 via a short-circuit pin 155. The capacitor electrode 152 faces the high-side electrode 151 so as to form capacitance. The capacitor electrode 152 is connected to the low-side electrode 153 via a short-circuit pin 156.

The wireless IC device 1w receives a high-frequency signal radiated from a reader/writer (not shown) atthe radiating plate 20. By resonatingthe powerfeeding circuit 150 that is magnetically and capacitively coupled with the radiating plate 20, the wireless IC device 1w supplies the wireless IC chip 5 with only a reception signal in a predetermined frequency band. Meanwhile, the wireless IC device 1w extracts predetermined energy from the reception signal, and by using this energy as a driving source, the wireless IC device 1w matches the information stored In the wireless IC chip 5 with a predetermined frequency at the power feeding circuit 150. Thereafter, The radiating plate 20 transmits the information to the reader/writer.

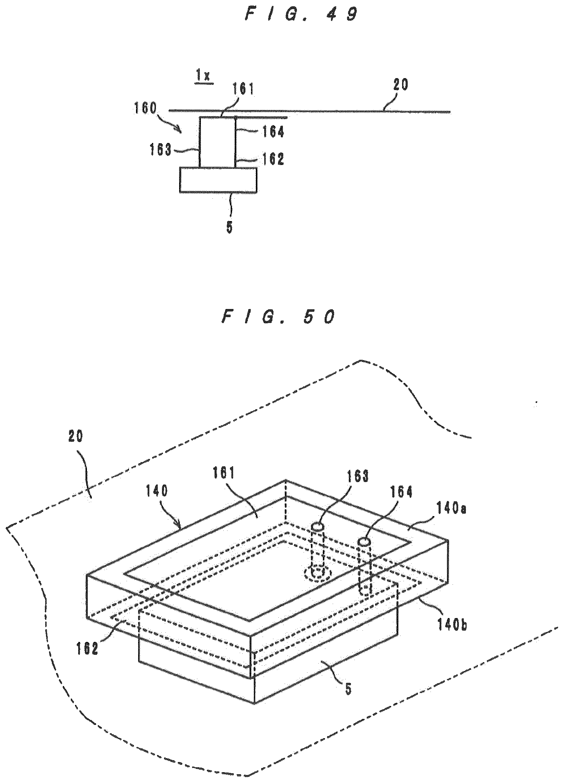

### Twenty-fifth Embodiment (refer to Figs. 49 and 50)

According to a twenty-fifth embodiment, a wireless IC device 1x includes a power feeding circuit 160 formed as a distributed-constant-type resonance circuit of an Inverted F antenna configuration. Fig. 49 illustrates an equivalent circuit of the wireless IC device 1 x. More specifically, as shown in Fig. 50, a power feeding circuit board 140 is a multilayer board made of ceramic sheets. The powerfeeding circuit board 140 includes a high-side electrode 161 disposed on a first surface 140a thereof and a low-side electrode 162 disposed on a second surface 140b thereof. The high-side electrode 161 Is electrically connected to a radiating plate 20 via magnetic coupling and capacitive coupling. The high-side electrode 161 is further connected to a high-side terminal of a wireless IC chip 5 via a power feeding pin 163. The low-side electrode 162 is connected to a low-side terminal of the wireless IC chip 5. The low-side electrode 162 is further connected to the high-side electrode 161 via a short-circuit pin 164.

The wireless IC device 1x receives a high-frequency signal radiated from a reader/writer (not shown) atthe radiating plate 20. By resonatingthe powerfeeding circuit 160 that is magnetically and capacitively coupled with the radiating plate 20, the wireless IC device 1 x supplies the wireless IC chip 5 with only a reception signal in a predetermined frequency band. Meanwhile, the wireless IC device 1x extracts predetermined energy from the reception signal, and by using this energy as a driving source, the wireless IC device 1x matches the information stored in the wireless IC chip 5 with a predetermined frequency at the power feeding circuit 160. Thereafter, the radiating plate 20 transmits the information to the reader/writer.

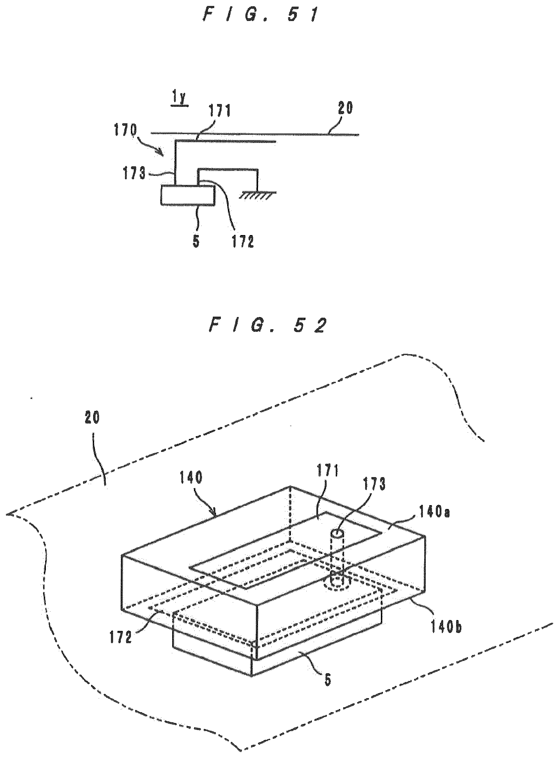

### Twenty-sixth Embodiment (refer to Figs. 51 and 52)

According to a twenty-sixth embodiment, a wireless IC device 1y includes a power feeding circuit 170 formed as a distributed-constant-type resonance circuit of an inverted L antenna configuration. Fig. 51 illustrates an equivalent circuit of the wireless IC device 1y. More specifically, as shown in Fig. 52, a power feeding circuit board 140 is a multilayer board made of ceramic sheets. The power feeding circuit board 140 includes a high-side electrode 171 disposed on a first surface 140a thereof and a low-side electrode 172 disposed on a second surface 140b thereof. The high-side electrode 171 is electrically connected to a radiating plate 20 via magnetic coupling and capacitive coupling. The high-side electrode 171 is further connected to a high-side terminal of a wireless IC chip 5 via a power feeding pin 173. The low-side electrode 172 is connected to a low-side terminal of the wireless IC chip 5.

The wireless IC device 1y receives a high-frequency signal radiated from a reader/writer (not shown) atthe radiating plate 20. By resonating the powerfeeding circuit 170 that is magnetically and capacitively coupled with the radiating plate 20, the wireless IC device 1 y supplies the wireless IC chip 5 with only a reception signal in a predetermined frequency band. Meanwhile, the wireless IC device 1y extracts predetermined energy from the reception signal, and by using this energy as a driving source, the wireless IC device 1y matches the information stored in the wireless IC chip 5 with a predetermined frequency at the power feeding circuit 170. Thereafter, the radiating plate 20 transmits the information to the reader/writer.

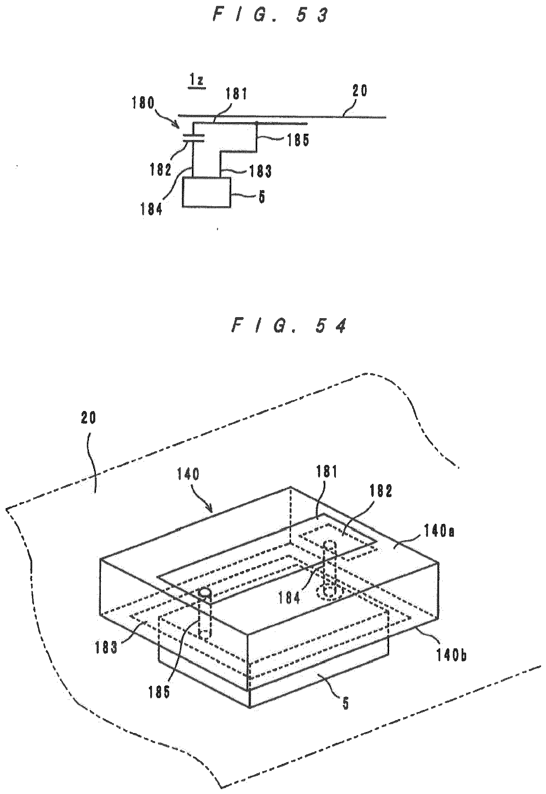

### Twenty-seventh Embodiment (refer to Figs. 53 and 54)

According to a twenty-seventh embodiment, a wireless IC device 1z includes a power feeding circuit 180 formed as a distributed-constant-type resonance circuit of an inverted L antenna configuration. Fig. 53 illustrates an equivalent circuit of the wireless IC device 1 z. More specifically, as shown in Fig. 54, a power feeding circuit board 140 is a multilayer board made of ceramic sheets. The power feeding circuit board 140 includes a high-side electrode 181 disposed on a first surface 140a thereof, a capacitor electrode 182 inside, and a low-side electrode 183 disposed on a second surface 140b thereof. The high-side electrode 181 is electrically connected to a radiating plate 20 via magnetic coupling and capacitlve coupling. The capacitor electrode 182 faces the high-side electrode 181 so as to form capacitance. The capacitor electrode 182 is connected to a high-side terminal of the wireless IC chip 5 via a power feeding pin 184. The low-side electrode 183 Is connected to a low-side terminal of the wireless IC chip 5. The low-side electrode 183 is further connected to the high-side electrode 181 via a short-circuit pin 185.

The wireless IC device 1z receives a high-frequency signal radiated from a reader/writer (not shown) at the radiating plate 20. By resonatingthe powerfeeding circuit 170 that is magnetically and capacitively coupled with the radiating plate 20, the wireless IC device 1 z supplies the wireless IC chip 5 with only a reception signal in a predetermined frequency band. Meanwhile, the wireless IC device 1z extracts predetermined energy from the reception signal, and by using this energy as a driving source, the wireless IC device 1z matches the information stored in the wireless IC chip 5 with a predetermined frequency at the power feeding circuit 180. Thereafter, the radiating plate 20 transmits the information to the reader/writer.

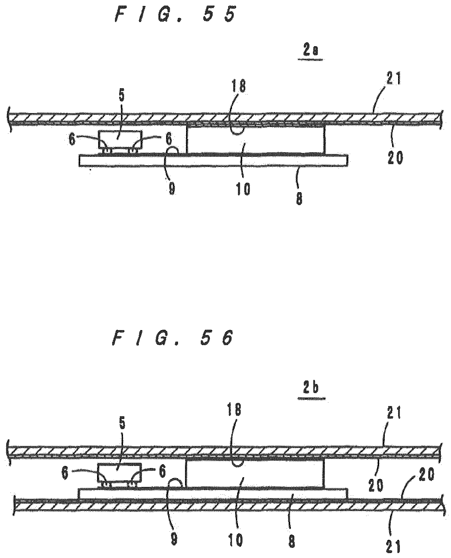

### Twenty-eighth Embodiment (refer to Fig. 55)

According to a twenty-eighth embodiment, as shown in Fig. 55, a wireless IC device 2a is configured so that a wireless IC chip 5 and a power feeding circuit board 10 are mounted on a rigid wiring board 8 so as to be parallel to each other, and the power feeding circuit board 10 is bonded to a radiating plate 20 by an adhesive agent 18. For example, the power feeding circuit board 10 includes the power feeding circuit 16 shown in Fig. 2. The power feeding circuit board 10 is electrically connected to the wireless IC chip 5 via a plurality of conductors 9 provided on the wiring board 8.

In the wireless IC device 2a, the powerfeeding circuit 16 Is mainly magnetically coupled with the radiating plate 20. Thus, the operation and advantages of the twenty-eighth embodiment are similarto those of the first embodiment. In this way, the wireless IC device 2a communicates with a reader/writer. The powerfeeding circuit board 10 in the twenty-eighth embodiment may be not only the power feeding circuit board employed in the first embodiment but also any of the power feeding circuit boards employed in the above-described embodiments. This point can also be applied to the following twenty-ninth embodiment.

### Twenty-ninth Embodiment (refer to Fig. 56)

According to a twenty-ninth embodiment, as shown in Fig. 56, a wireless IC device 2b is configured so that one more radiating plate 20 is bonded to the wiring board 8 according to the twenty-eighth embodiment, and the pair of radiating plates 20 sandwiches the wireless IC chip 5, the power feeding circuit board 10, and the wiring board 8. The operation of the wireless IC device 2b Is similar to that of the twenty-eighth embodiment. In particular, a magnetic coupling efficiency between the power feeding circuit 16 and the pair of radiating plates 20 is improved.

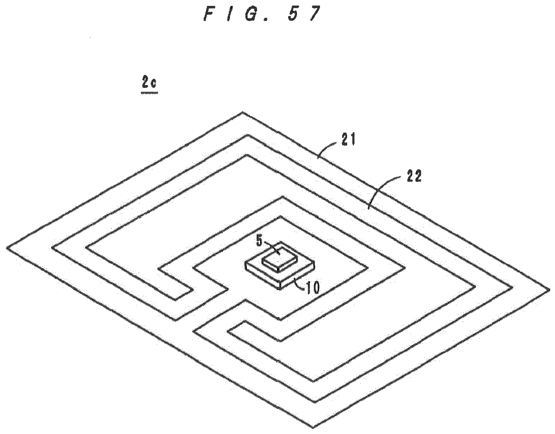

### Thirtieth Embodiment (refer to Fig. 57)

According to a thirtieth embodiment, as shown in Fig. 57, a wireless IC device 2c is configured so that a radiating plate 22 shaped in a double closed loop is disposed in a lateral symmetrical manner on a surface of a resin film 21. A power feeding circuit board 10 having the wireless IC chip 5 mounted thereon is disposed in the center portion of the inner loop of the radiating plate 22.

According to the present embodiment, the power feeding circuit board 10 is disposed in the vicinity of the radiating plate 22 without being bonded to the radiating plate 22. Since the radiating plate 22 has is in the shape of a loop, the linearly measured length of the radiating plate 22 is small. As in the above-described embodiments, in such a configuration, electromagnetic induction coupling is achieved between the powerfeeding circuit board 10 and the radiating plate 22. Thus, a signal is exchanged between the power feeding circuit board 10 and the radiating plate 22. In this way, the wireless IC device 2c can communicate with a reader/writer. In addition, the powerfeeding circuit board 10 can be disposed around the center portion ofthe radiating plate 22. Therefore, precise positioning of the power feeding circuit board 10 is not required.

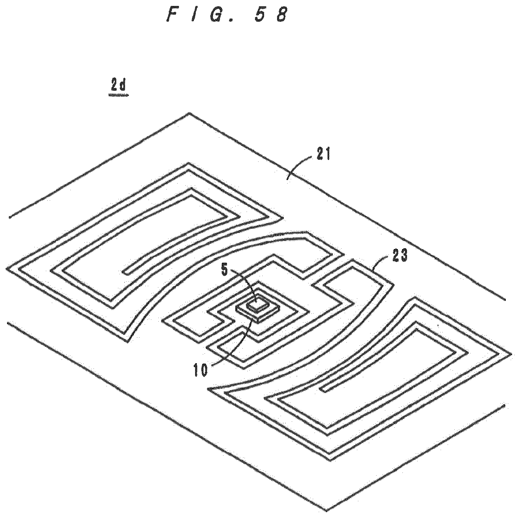

### Thirty-first Embodiment (refer to Fig. 58)

According to a thirty-first embodiment, as shown in Fig. 58, a wireless IC device 2d is configured so that a radiating plate 23 having a combination of a meandering shape, a loop shape, and a spiral shape is disposed in a lateral symmetric manner on a surface of a resin film 21. A power feeding circuit board 10 having the wireless IC chip 5 mounted thereon is disposed in the center portion of the inner loop of the radiating plate 23.

According to the thirty-first embodiment, like the thirtieth embodiment, the power feeding circuit board 10 is disposed in the vicinity of the radiating plate 23 without being bonded to the radiating plate 23. Since the radiating plate 23 has a combination of a meandering shape, a loop shape, and a spiral shape, the linearly measured length of the radiating plate 23 is small. As in the above-described embodiments, in such a configuration, electromagnetic induction coupling Is achieved between the powerfeeding circuit board 10 and the radiating plate 23. Thus, a signal is exchanged between the powerfeeding circuit board 10 and the radiating plate 23. In this way, the wireless IC device 2d can communicate with a reader/ writer. In addition, like the thirtieth embodiment, precise positioning of the power feeding circuit board 10 is not required.

### Other Embodiments

Although the wireless IC device according to the present invention has been shown and described with reference to the foregoing embodiments, many changes can be made without departing from the spirit and scope of the invention as defined in the following claims.

For example, the detailed internal structure of the power feeding circuit board and the detailed shapes of the radiating plate and the film can be freely determined. In addition, in order to connect the wireless IC device onto the power feeding circuit board, a method other than the method in which a solder bump is used may be employed. Furthermore, the powerfeeding circuit board is not necessarily rigid, but the power feeding circuit board may be a flexible board made of an organic resin material (e.g., polyimide or liquid crystal polymer).

### Industrial Applicability

As noted above, the present invention can be effectively applied to a wireless IC device. In particular, the present invention is advantageous in that wireless IC devices having stable frequency characteristics can be obtained.

## Claims

1. A wireless IC device comprising:
a wireless IC chip;
a power supply circuit board connected to the wireless IC chip, and including a power supply circuit including a resonant circuit having a predetermined resonant frequency; and
a radiation plate, to which the power supply circuit board is adhered or disposed adjacent thereto, arranged to perform at least one of radiation of a transmission signal supplied from the power supply circuit, and receiving of a reception signal and supplying of the reception signal to the power supply circuit,
wherein the resonant circuit is a distributed-constant resonant circuit.

2. The wireless IC device according to claim 1, wherein the wireless IC chip is mounted on the power supply circuit board.

3. The wireless IC device according to one of claims 1 or 2, wherein the power supply circuit board is a rigid board, and the radiation plate is made of a flexible metal film.

4. The wireless IC device according to claim 3, wherein the flexible metal film is retained in a flexible resin film.

5. The wireless IC device according to one of claims 1 to 4, wherein the electrical length of the radiation plate is an integer multiple of a half wavelength of the resonant frequency.

6. The wireless IC device according to one of claims 1 to 5, wherein the power supply circuit is an inverted F antenna configuration.

7. The wireless IC device according to one of claims 1 to 5, wherein the power supply circuit is an inverted L antenna configuration.

8. The wireless IC device according to one of claims 6 or 7,
wherein the power supply circuit includes a first electrode disposed on a first surface of the power supply circuit board and connected to a first terminal of the wireless IC chip via a short circuit pin and a second electrode disposed on a second surface of the power supply circuit board and connected to a second terminal of the wireless IC chip,
wherein the radiating plate and the first electrode face each other and are electrically coupled.

9. The wireless IC device according to one of claims 1 to 5, wherein
the radiation plate and the power supply circuit board are capacitive coupled to each other.

10. A component for a wireless IC device comprising:
a wireless IC chip; and
a power supply circuit board connected to the wireless IC chip including a power supply circuit, and a resonant circuit having a predetermined resonant frequency,
wherein the resonant circuit is a distributed-constant resonant circuit.
